# EUROPEAN PATENT APPLICATION

(11) **EP 4 775 543 A1**
(43) Date of publication of application: **15.07.2026**
(21) Application number: 24862769.7
(22) Date of filing: 03.09.2024
(51) Int. Cl.: C01G 33/00, C01B 25/45, C09C 1/00, C09D 7/62, C09D 17/00, C09D 201/00, H01M 4/13, H01M 4/36, H10N 30/074, H10N 30/853

(54) **NIOBIC ACID COMPOUND DISPERSION AND METHOD FOR PRODUCING SAME**

(30) Priority: 08.09.2023 JP 2023146511; 07.03.2024 JP 2024034993
(71) Applicant: Mitsui Kinzoku Company, Limited, Tokyo 141-8584 (JP)
(72) Inventor: MIURA Takashi, Omuta-shi, Fukuoka 836-0003 (JP); MOTONO Ryuji, Omuta-shi, Fukuoka 836-0003 (JP); HARA Syuhei, Omuta-shi, Fukuoka 836-0003 (JP)
(74) Representative: Parker, Andrew James
(86) International application number: PCT/JP2024/031530
(87) International publication number: WO 2025/053117

(57) **Abstract**

A niobic acid compound dispersion of the present invention contains niobium, contains one or more elements X selected from the group consisting of alkali metal elements and alkaline earth metal elements, and a phosphorus compound and/or a chlorine compound, and has a particle size (D50) of 1000 nm or less as measured by a dynamic light scattering method. The niobic acid compound dispersion of the present invention contains niobium, contains one or more elements X selected from the group consisting of alkali metal elements and/or alkaline earth metal elements, and a phosphorus compound and/or a chlorine compound, and has a maximum transmittance value of 70%T or more in a wavelength region of 400 nm to 760 nm.

## Description

### Technical Field

The present invention relates to a niobic acid compound dispersion and a method for producing the same.

### Background Art

A single crystal of lithium niobate which is a niobic acid compound is used as a nonlinear optical material, a piezoelectric material, or a battery material. In composite active material particles capable of reducing battery resistance generated in an all-solid-state lithium ion battery, examples of a lithium ion conductive oxide that coats at least a part of a surface of the composite active material particles include lithium niobate. Patent Literature 1 discloses a piezoelectric sensor in which a piezoelectric film layer containing lithium niobate powder is formed on a substrate layer of the piezoelectric sensor. In Patent Literature 1, a mixture obtained by mixing a lithium niobate powder and a sol-gel solution is spray-applied and then sintered to form the piezoelectric film layer.

### Citation List

### Patent Literature

Patent Literature 1: JP 2023-63187 A

### Summary of Invention

### Technical Problem

However, when the mixture obtained by mixing the lithium niobate powder and the sol-gel solution is spray-applied, if dispersibility and solubility of the lithium niobate powder in a solvent are low, it is difficult to form a uniform piezoelectric film layer. If storage stability of the mixture of the lithium niobate powder and the solvent is poor, a spray applying operation is complicated. Therefore, in addition to high dispersibility and solubility in a solvent, excellent storage stability is required.

In view of the above problems, the present invention provides a niobic acid compound dispersion having high dispersibility in a polar solvent, particularly water, favorable solubility in water, and excellent storage stability, and a method for producing the same.

### Solution to Problem

A niobic acid compound dispersion of the present invention, obtained in order to solve the above problems is a niobium-containing niobic acid compound dispersion, characterized in that the niobic acid compound dispersion contains one or more elements X selected from the group consisting of alkali metal elements and/or alkaline earth metal elements, and a phosphorus compound and/or a chlorine compound, and a particle size (D50) of particles in the niobic acid compound dispersion as measured by a dynamic light scattering method is 1000 nm or less.

When the niobic acid compound dispersion of the present invention contains niobium, contains one or more elements X selected from the group consisting of alkali metal elements and/or alkaline earth metal elements, and a phosphorus compound and/or a chlorine compound, and a particle size (D50) of particles in the niobic acid compound dispersion as measured by a dynamic light scattering method is 1000 nm or less, it is preferable from a viewpoint of improving dispersibility and solubility in a polar solvent, particularly water.

The niobic acid compound dispersion of the present invention contains niobium. It is considered that niobium is present as an oxide in the niobic acid compound dispersion of the present invention, for example, as an anion such as NbO₃⁻ or a polyoxometalate (polyacid) ion in which a plurality of niobium atoms and oxygen atoms are bonded.

The niobic acid compound dispersion of the present invention contains one or more elements X selected from the group consisting of alkali metal elements and/or alkaline earth metal elements. That is, it is presumed that the niobium acid in the niobic acid compound dispersion of the present invention is present as an ion ionically bonded to ions of one or more elements X selected from the group consisting of alkali metal elements and/or alkaline earth metal elements in the dispersion. It is considered that, in the niobic acid compound dispersion of the present invention, a hydroxide ion is present as an anion, while a halide ion such as a fluoride ion or a chloride ion is hardly present, and an alkali metal element and an alkaline earth metal element are present as cations. Therefore, niobium is considered to be present as an anion such as NbO₃⁻ or a polyoxometalate (polyacid) ion in which a plurality of niobium atoms and oxygen atoms are bonded.

Furthermore, the element X preferably contains Li. In addition, the element X is not limited to only one alkali metal element of Li, and suitably contains two alkali metal elements of Li and Na or Li and K, or three alkali metal elements of Li, Na, and K. Furthermore, the element X may be one alkali metal element of Na or K, or may contain two alkali metal elements of Na and K.

The niobic acid compound dispersion of the present invention contains a phosphorus compound. In the niobic acid compound dispersion of the present invention, the phosphorus compound preferably contains one or more selected from an inorganic phosphorus compound, an organic phosphorus compound, and a salt thereof.

Examples of the inorganic phosphorus compound include inorganic phosphoric acids, particularly phosphoric acids, phosphonic acids, and phosphinic acids. Specific examples of the phosphoric acids include phosphoric acid (CAS No. 7664-38-2), a condensed phosphoric acid, pyrophosphoric acid (CAS No. 2466-09-3), and polyphosphoric acid (CAS No. 8071-16-1). Examples of the phosphonic acids include phosphorous acid (CAS No. 13598-36-2) and hypophosphorous acid (CAS No. 6303-21-5). Examples of the phosphinic acids include phosphinic acid (CAS No. 6303-21-5).

Examples of the organic phosphorus compound include phosphates, organic phosphites, organic phosphonic acids, and organic phosphines. Specific examples of the organic phosphorus compound include methyl phosphate (CAS No. 52932-95-3), ethyl phosphate (CAS No. 37203-76-2), butyl phosphate (CAS No. 107-66-4), phenyl phosphate (CAS No. 701-64-4), dimethyl phosphate (CAS No. 813-78-5), diethyl phosphate (CAS No. 598-02-7), dibutyl phosphate (CAS No. 107-66-4), diphenyl phosphate (CAS No. 838-85-7), trimethyl phosphate (CAS No. 512-56-1), triethyl phosphate (CAS No. 78-40-0), tributyl phosphate (CAS No. 126-73-8), and triphenyl phosphate (CAS No. 115-86-6).

Examples of the organic phosphites and the organic phosphonates include methylphosphonic acid (CAS No. 993-13-5), ethylphosphonic acid (CAS No. 6779-09-5), butylphosphonic acid (CAS No. 3321-64-0), phenylphosphonic acid (CAS No. 1571-33-1), dimethyl phosphite (dimethyl phosphonate) (CAS No. 868-85-9), diethyl phosphite (diethyl phosphonate) (CAS No. 762-04-9), dibutyl phosphite (dibutyl phosphonate) (CAS No. 1809-19-4), diphenyl phosphite (diphenyl phosphonate) (CAS No. 4712-55-4), trimethyl phosphite (CAS No. 121-45-9), triethyl phosphite (CAS No. 122-52-1), tributyl phosphite (CAS No. 102-85-2), and triphenyl phosphite (CAS No. 101-02-0).

Examples of the salts of the inorganic phosphorus compound and/or the organic phosphorus compound include ammonium salts of the inorganic phosphorus compound and/or the organic phosphorus compound, a salt with an organic nitrogen compound, an alkali metal salt, and an alkaline earth metal salt.

Examples of the organic phosphinic acids include triphenylphosphine (CAS No. 603-35-0).

Examples of the inorganic ammonium phosphate, the salt with an organic nitrogen compound, the alkali metal salt, and the alkaline earth metal salt include ammonium phosphate, primary ammonium phosphate (CAS No. 7722-76-1), secondary ammonium phosphate (CAS No. 7783-28-0), sodium metaphosphate (CAS No. 10361-03-2), potassium metaphosphate (CAS No. 7790-53-6), sodium hexametaphosphate (CAS No. 10124-56-8), potassium hexametaphosphate, sodium pyrophosphate (CAS No. 7722-88-5), potassium pyrophosphate (CAS No. 7320-34-5), sodium polyphosphate (CAS No. 68915-31-1), potassium polyphosphate, sodium tripolyphosphate (CAS No. 7758-29-4), potassium tripolyphosphate (CAS No. 13845-36-8), sodium ultrapolyphosphate, and potassium ultrapolyphosphate.

In the niobic acid compound dispersion of the present invention, the phosphorus compound preferably contains one or more selected from phosphoric acid (CAS No. 7664-38-2), a condensed phosphoric acid, pyrophosphoric acid (CAS No. 2466-09-3), polyphosphoric acid (CAS No. 8071-16-1), phosphorous acid (CAS No. 13598-36-2), hypophosphorous acid (CAS No. 6303-21-5), ammonium phosphate, primary ammonium phosphate (CAS No. 7722-76-1), secondary ammonium phosphate (CAS No. 7783-28-0), ammonium pyrophosphate, and ammonium polyphosphate. When the phosphorus compound contains phosphoric acid and a salt of phosphoric acid, it is more preferable when a solution having a pH closer to neutrality is adjusted. On the other hand, when the phosphorus compound is a condensed phosphoric acid such as pyrophosphoric acid or polyphosphoric acid, or a salt of the condensed phosphoric acid, it is more preferable when a solution having a high pH is adjusted.

Note that, in the present specification, "phosphoric acid" refers to orthophosphoric acid, and does not include phosphoric acids such as pyrophosphoric acid, polyphosphoric acid, and phosphorous acid. The phosphorus compound may form a compound with an alkali metal element or an alkaline earth metal element. For example, when the phosphorus compound contains a hydroxy group (P-OH group), the phosphorus compound has a structure in which some or all of hydrogen atoms in the hydroxy group are replaced with an alkali metal element or an alkaline earth metal element.

The niobic acid compound dispersion of the present invention further contains a chlorine compound.

Examples of the chlorine compound include hydrochloric acid (CAS number: 7647-01-0), hypochlorous acid (CAS number: 7790-92-3), chlorous acid (CAS number: 13898-47-0), chloric acid (CAS number: 7790-93-4), and perchloric acid (CAS number: 7601-90-3).

The chlorine compound may be a salt of the chlorine compound described above, and examples thereof include an ammonium salt, an amine salt, a quaternary ammonium salt, and a lithium salt. The chlorine compound is preferably an ammonium salt or a lithium salt. Specific examples thereof include ammonium chloride (CAS No. 12125-02-9), ammonium perchlorate (CAS No. 7790-98-9), lithium chloride (CAS No. 7447-41-8), lithium perchlorate (CAS No. 7791-03-9), methylamine hydrochloride (CAS No. 593-51-1), and dimethylamine hydrochloride (CAS No. 506-59-2).

Note that, in a case where corrosion of a substrate to which the niobic acid compound dispersion of the present invention is applied or elution of the substrate is concerned depending on a material, a type, and the like of the substrate if the niobic acid compound dispersion of the present invention contains a chlorine compound, the niobic acid compound dispersion preferably contains no chlorine compound. For example, when the niobic acid compound dispersion of the present invention is used for coating a lithium ion secondary battery positive electrode or a positive electrode material, which will be described later, the niobic acid compound dispersion preferably contains no chlorine compound.

Furthermore, when a particle size (D50) of particles in the niobic acid compound dispersion as measured by a dynamic light scattering method is 1000 nm or less, dispersibility is high, a temporal change is small, and the niobic acid compound dispersion is stable, which is preferable from a viewpoint of reactivity in reaction with other substances or complexation, and film uniformity during film formation. The particle size (D50) is preferably a smaller particle size, more preferably 800 nm or less, still more preferably 600 nm or less, particularly preferably 500 nm or less, more particularly preferably 300 nm or less, still more particularly preferably 200 nm or less, further still more particularly preferably 100 nm or less, further still more preferably 50 nm or less, further still more preferably 30 nm or less, further still more preferably 20 nm or less, further still more preferably 10 nm or less, further still more particularly preferably 8 nm or less, further still more particularly preferably 6 nm or less, further still more particularly preferably 4 nm or less, further still more particularly preferably 2 nm or less, further still more preferably 1 nm or less, further still more preferably 0.6 nm or less, and most preferably more than 0. As described above, a liquid in which the particle size (D50) of particles in the niobic acid compound dispersion of the present invention is 1000 nm or less as a result of measurement of the particle size (D50) using a dynamic light scattering method is referred to as a "niobic acid compound dispersion" of the present invention.

Here, the dynamic light scattering method is a method in which light scattering intensity from a group of particles moving in a Brownian motion is measured by irradiating a solution such as a suspension solution with light such as laser light, and a particle size and a distribution thereof are obtained from a temporal variation of the intensity. Specifically, a method for evaluating the particle size distribution is performed in accordance with JIS Z 8828:2019 "Particle size analysis-dynamic light scattering method" using a zeta potential/particle size/molecular weight measurement system (ELSZ-2000 manufactured by Otsuka Electronics Co., Ltd.). Note that a solution to be measured is filtered with a filter having a pore size of 1 µm immediately before measurement in order to remove dust or the like in the solution. Note that the particle size (D50) refers to a median size (D50) that is a particle size indicating a 50% integrated value of an integrated distribution curve. In the present specification, unless otherwise specified, "particle size (D50)" includes both "initial particle size D50" indicating the particle size (D50) of particles in the niobic acid compound dispersion of the present invention, adjusted to a liquid temperature of 25°C immediately after generation, and "temporal particle size D50" indicating the particle size (D50) of particles in the niobic acid compound dispersion after the niobic acid compound dispersion is allowed to stand in a thermostat set at a room temperature of 25°C for one month from the day on which the niobic acid compound dispersion of the present invention is generated.

The niobic acid compound dispersion of the present invention is a niobium-containing niobic acid compound dispersion, characterized in that the niobic acid compound dispersion contains one or more elements X selected from the group consisting of alkali metal elements and/or alkaline earth metal elements, and a phosphorus compound and/or a chlorine compound, and has a maximum transmittance value of 70%T or more in a wavelength region of 400 nm to 760 nm.

Here, niobium, the one or more elements X selected from the group consisting of alkali metal elements and/or alkaline earth metal elements, and the phosphorus compound and/or the chlorine compound in the niobic acid compound dispersion of the present invention are as described above, and thus detailed description thereof is omitted.

When the niobic acid compound dispersion of the present invention has a maximum transmittance value of 70%T or more in a wavelength region of 400 nm to 760 nm, it is preferable from a viewpoint of high dispersibility and excellent uniformity of components in the liquid. The maximum transmittance value in the wavelength region of 400 nm to 760 nm is more preferably 72%T or more, still more preferably 74%T or more, particularly preferably 76%T or more, more particularly preferably 78%T or more, still more particularly preferably 80%T or more, further still more particularly preferably 85%T or more, further still more preferably 90%T or more, further still more preferably 95%T or more, further still more particularly preferably 97%T or more, further still more preferably 98%T or more, further still more preferably 99%T or more, and most preferably 100%T.

The niobic acid compound dispersion of the present invention may have transmittance of 70%T or more at any one or two or more of wavelengths of 400 nm, 600 nm, and 750 nm. The transmittance at any one or two or more of wavelengths of 400 nm, 600 nm, and 750 nm may be 72%T or more, 74%T or more, 76%T or more, 78%T or more, 80%T or more, 85%T or more, 90%T or more, 95%T or more, 97%T or more, 98%T or more, 99%T or more, or 100%T or more.

Furthermore, the niobic acid compound dispersion of the present invention may have a minimum transmittance value of 70%T or more in a wavelength region of 400 nm to 760 nm. The minimum transmittance value in the wavelength region of 400 nm to 760 nm may be 72%T or more, 74%T or more, 76%T or more, 78%T or more, 80%T or more, 85%T or more, 90%T or more, 95%T or more, 97%T or more, 98%T or more, 99%T or more, or 100%T or more.

Note that a measured value of the above-described transmittance may exceed 100%T due to a measurement error or the like, but since a theoretical upper limit value is 100%T, when the measured value exceeds 100%T, it is regarded as 100%T. As described above, a liquid in which the maximum transmittance value of the niobic acid compound dispersion of the present invention in the wavelength region of 400 nm to 760 nm is 70%T or more is defined as a "niobic acid compound dispersion" of the present invention. In the present specification, unless otherwise specified, "transmittance" includes both "initial transmittance" indicating the transmittance of the niobic acid compound dispersion of the present invention adjusted to a liquid temperature of 25°C immediately after generation, and "temporal transmittance" indicating the transmittance of the niobic acid compound dispersion after the niobic acid compound dispersion is allowed to stand in a thermostat set at a room temperature of 25°C for one month from the day on which the niobic acid compound dispersion of the present invention is generated.

Here, the above-described transmittance is determined by measuring an ultraviolet-visible absorption spectrum (UV-Vis absorption spectrum) of the niobic acid compound dispersion of the present invention according to the following transmittance measurement conditions in accordance with JIS K 0115, 2004 "General rules for molecular absorptiometric analysis".

### =Transmittance measurement conditions=

- Measuring apparatus: ultraviolet visible near-infrared spectrophotometer UH4150 type (manufactured by Hitachi High-Tech Science Corporation)
- Measurement mode: wavelength scan
- Data mode:%T (transmitting)
- Measurement wavelength range: 200 nm to 2000 nm
- Scan speed: 600 nm/min
- Sampling interval: 2 nm

Note that the "dispersion" in the present invention is not limited to one in which a solute is dispersed or mixed in a state of a single molecule in a solvent, and also includes one in which an aggregate in which a plurality of molecules are attracted by intermolecular interaction, for example, (1) a multimer molecule, (2) a solvate molecule, (3) a molecular cluster, (4) a colloidal particle, or the like is dispersed in a solvent.

The niobic acid compound dispersion of the present invention may further contain ammonia and/or an organic nitrogen compound.

The niobic acid compound dispersion of the present invention may contain an ionized alkaline aqueous solution, for example, ammonia or an organic nitrogen compound. Note that the content of each of ammonia and the organic nitrogen compound in the niobic acid compound dispersion of the present invention is preferably 10% by mass or less, more preferably 5% by mass or less, still more preferably 3% by mass or less, and particularly preferably 1% by mass or less with respect to 100% by mass of the niobic acid compound dispersion of the present invention.

As described in detail in a method for producing a niobic acid compound dispersion of the present invention described later, in the production process, a niobium acid-containing precipitate which is a niobium-containing precipitation slurry, for example, a hydrous ammonium niobate cake is generated by a reverse neutralization method in which an acidic niobium complex aqueous solution is added to an alkaline aqueous solution, for example, ammonia water, and then the niobic acid compound dispersion of the present invention is generated. Therefore, it is considered that ammonia contains ammonium ions and is present as a cation in the dispersion. In addition, in the production process, the niobium acid-containing precipitate obtained through the reverse neutralization method for addition to ammonia water is mixed with an organic nitrogen compound to generate a niobium compound neutralized aqueous solution. Therefore, it is considered that the organic nitrogen compound is present as a cation in the dispersion.

Examples of a method for measuring the content of ammonia present in the dispersion include a method in which sodium hydroxide is added to the dispersion, ammonia is distilled and separated, and the ammonia content is quantified by an ion meter, a method in which a N₂ content in a gasified sample is quantified by a thermal conductivity meter, a Kjeldahl method, gas chromatography (GC), ion chromatography, and gas chromatography mass spectrometry (GC-MS). In particular, the method for quantifying an ammonia content by an ion meter is preferable.

Examples of the organic nitrogen compound include an aliphatic amine, an aromatic amine, an amino alcohol, an amino acid, a polyamine, a quaternary ammonium, a guanidine compound, and an azole compound.

Examples of the aliphatic amine include methylamine, dimethylamine, trimethylamine, ethylamine, methylethylamine, diethylamine, triethylamine, methyldiethylamine, dimethylethylamine, n-propylamine, din-propylamine, tri-n-propylamine, iso-propylamine, di-iso-propylamine, tri-iso-propylamine, n-butylamine, di-n-butylamine, tri-n-butylamine, iso-butylamine, di-iso-butylamine, tri-iso-butylamine and tert-butylamine, n-pentane amine, n-hexylamine, cyclohexylamine, and piperidine.

Examples of the aromatic amine include aniline, phenylenediamine, and diaminotoluene. Furthermore, examples of the amino alcohol include methanolamine, ethanolamine, propanolamine, butanolamine, pentanolamine, dimethanolamine, diethanolamine, trimethanolamine, methylmethanolamine, methylethanolamine, methylpropanolamine, methylbutanolamine, ethylmethanolamine, ethylethanolamine, ethylpropanolamine, dimethylmethanolamine, dimethylethanolamine, dimethylpropanolamine, methyldimethanolamine, methyldiethanolamine, diethylmethanolamine, trishydroxymethylaminomethane, bis(2-hydroxyethyl) aminotris(hydroxymethyl) methane, and aminophenol. Examples of the amino acid include alanine, arginine, aspartic acid, and EDTA. Furthermore, examples of the polyamine include a polyamine and a polyether amine.

Examples of the quaternary ammonium include an alkylimidazolium, a pyridinium, a pyrrolidium, and a tetraalkylammonium. Here, specific examples of the alkylimidazolium include 1-methyl-3-methylimidazolium, 1-ethyl-3-methylimidazolium, 1-propyl-3-methylimidazolium, 1-butyl-3-methylimidazolium, 1-hexyl-3-methylimidazolium, 1-methyl-2,3-dimethylimidazolium, 1-ethyl-2,3-dimethylimidazolium, 1-propyl-2,3-dimethylimidazolium, and 1-butyl-2,3-dimethylimidazolium. Specific examples of the pyridinium and the pyrrolidium include N-butyl-pyridinium, N-ethyl-3-methyl-pyridinium, N-butyl-3-methyl-pyridinium, N-hexyl-4-(dimethylamino)-pyridinium, N-methyl-1-methylpyrrolidinium, and N-butyl-1-methylpyrrolidinium. Furthermore, specific examples of the tetraalkylammonium include tetramethylammonium, tetraethylammonium, tetrabutylammonium, and ethyl-dimethyl-propylammonium. Note that examples of an anion that forms a salt with the above-described cation include OH⁻, Cl⁻, Br⁻, I⁻, BF₄⁻, and HSO₄⁻.

Examples of the guanidine compound include guanidine, diphenylguanidine, and ditolylguanidine. Examples of the azole compound include an imidazole compound and a triazole compound. Here, specific examples of the imidazole compound include imidazole, 2-methylimidazole, and 2-ethyl-4-methylimidazole. Specific examples of the triazole compound include 1,2,4-triazole, methyl 1,2,4-triazole-3-carboxylate, and 1,2,3-benzotriazole.

Here, the organic nitrogen compound is preferably an aliphatic amine because the aliphatic amine has high volatility and low toxicity. Specifically, the organic nitrogen compound is more preferably an aliphatic amine having 1 to 4 carbon atoms, and particularly preferably an aliphatic amine having 1 or more and 2 or less carbon atoms. Examples thereof include methylamine and dimethylamine.

In addition, the organic nitrogen compound is preferably a quaternary ammonium from a viewpoint of having not only high solubility but also high crystallization suppression and high solation suppression. For example, a tetraalkylammonium salt is preferable, a tetraalkylammonium hydroxide salt is more preferable, tetramethylammonium hydroxide and tetraethylammonium are particularly preferable, and tetramethylammonium hydroxide (TMAH) is more particularly preferable.

Furthermore, the organic nitrogen compound may be a mixture of two or more selected from an aliphatic amine, an aromatic amine, an amino alcohol, an amino acid, a polyamine, a quaternary ammonium, a guanidine compound, and an azole compound without being one selected therefrom. For example, a mixture of two compounds of an aliphatic amine and a quaternary ammonium is preferable from a viewpoint that solubility can be increased while an addition amount is suppressed so as not to increase toxicity.

Specific examples thereof include a mixture of two organic nitrogen compounds, such as methylamine and tetramethylammonium hydroxide (TMAH), dimethylamine and tetramethylammonium hydroxide (TMAH), or methylamine and dimethylamine, and a mixture of three organic nitrogen compounds, such as methylamine, dimethylamine, and tetramethylammonium hydroxide (TMAH).

Note that examples of a method for measuring the content of the organic nitrogen compound present in the niobic acid compound dispersion of the present invention include gas chromatography (GC), liquid chromatography (LC), mass spectrometry (MS), gas chromatography/mass spectrometry (GC-MS), and liquid chromatography/mass spectrometry (LC-MS). When an organic nitrogen compound having low volatility is contained, measurement of the content of the organic nitrogen compound by liquid chromatography (LC) or liquid chromatography/mass spectrometry (LC-MS) is preferable.

The niobic acid compound dispersion of the present invention is characterized in that the niobium content in the niobic acid compound dispersion is 0.01% by mass or more and 30% by mass or less in terms of Nb atoms.

The niobium content in the niobic acid compound dispersion of the present invention is preferably 0.01% by mass or more and 30% by mass or less in terms of Nb atoms from a viewpoint of achieving both practicality and stability of the niobic acid compound dispersion. The niobium content is more preferably 0.5% by mass or more and 25% by mass or less in terms of Nb atoms, still more preferably 1% by mass or more and 20% by mass or less in terms of Nb atoms, particularly preferably 1% by mass or more and 15% by mass or less in terms of Nb atoms, more particularly preferably 3% by mass or more and 10% by mass or less in terms of Nb atoms, and still more particularly preferably 5% by mass or more and 10% by mass or less in terms of Nb atoms.

Here, the niobium content in the niobic acid compound dispersion is calculated by appropriately diluting the dispersion with dilute hydrochloric acid as necessary, and measuring % by mass of Nb in terms of Nb atoms in accordance with JIS K0116:2014 using high frequency inductively coupled plasma emission spectrometry (ICP emission spectrometry (AG-5110 manufactured by Agilent Technologies)). In addition, when the niobic acid in the niobic acid compound dispersion of the present invention is one ionically bonded to an alkali metal or an alkaline earth metal, for example, a lithium niobate salt ionically bonded to a lithium ion, a lithium content may be calculated by measuring % by mass of Li in terms of Li atoms in a similar manner to the niobium content. By specifying the niobium content and the lithium content in the niobic acid compound dispersion of the present invention, a molar ratio Li/Nb of lithium (Li) to niobium (Nb) of lithium niobate contained in the niobic acid compound dispersion of the present invention can be specified. Note that the content of each of one or more elements X selected from the group consisting of alkali metal elements other than lithium and/or alkaline earth metal elements can also be calculated by measuring % by mass of each element X in terms of element X atoms in a similar manner to the niobium content.

The niobic acid compound dispersion of the present invention is characterized in that a phosphorus content in the niobic acid compound dispersion is 0.01% by mass or more and 10% by mass or less in terms of P atoms.

The phosphorus content in the niobic acid compound dispersion of the present invention is preferably 0.01% by mass or more and 10% by mass or less in terms of P atoms from a viewpoint of improving dispersibility and solubility in a polar solvent, particularly water. In addition, the phosphorus content is more preferably 0.1% by mass or more and 5% by mass or less in terms of P atoms, still more preferably 0.1% by mass or more and 2% by mass or less in terms of P atoms, particularly preferably 0.1% by mass or more and 1% by mass or less in terms of P atoms, and more particularly preferably 0.1% by mass or more and 0.4% by mass or less in terms of P atoms.

The phosphorus content in the niobic acid compound dispersion of the present invention is calculated by appropriately diluting the dispersion with dilute hydrochloric acid as necessary, and measuring % by mass of P in terms of P atoms in accordance with JIS K0116:2014 using ICP emission spectrometry (AG-5110 manufactured by Agilent Technologies).

In addition, the phosphorus content in the niobic acid compound dispersion of the present invention is preferably analyzed by the ICP emission spectrometry described above, but can also be determined by measuring a ³¹P-NMR spectrum. Specifically, the phosphorus content in the niobic acid compound dispersion of the present invention can be determined by the following procedure using a nuclear magnetic resonance apparatus (AVANCE NEO 600 manufactured by Bruker Corporation). By mixing 70 µL of the niobic acid compound dispersion of the present invention and 650 µL of a phosphonoacetic acid heavy water solution obtained by dissolving 10 g/L of phosphonoacetic acid in heavy water, a measurement sample is prepared. A ³¹P-NMR spectrum of the adjusted measurement sample is measured according to the following ³¹P-NMR spectrum measurement conditions.

### =³¹P-NMR spectrum measurement conditions=

- Magnetic field: 14.1 T (1 H 600 Mhz)
- Spectroscope: AVANCE NEO 600 manufactured by Bruker Corporation
- Measurement and data processing software: TopSpin manufactured by Bruker Corporation
- NMR probe: solvent probe (type: PA BBO 600S3 BBF-H-D-05 Z SP)
- Solvent: heavy water
- Internal sample for chemical shift value and phosphorus amount: phosphonoacetic acid
- Standard of chemical shift value: An apex of a central peak of a triplet peak of phosphonoacetic acid is set to 14.96 ppm.
- Spectrum center (O1 value - SR value (chemical shift value)): 0.00 ppm
- Radio wave pulse intensity: set to an intensity at which 14 µs is a 90 degree pulse with respect to a peak of an irradiation center.
- Radio wave pulse width: 14 µs
- Measurement interval: 80 µs (DW =40 µs on the software)
- Number of measurement points: 32768 points (TD =65536 on the software)
- Number of spectral points (SI on the software): 65536 points

By performing Fourier transform on FID data measured under the above-described ³¹P-NMR spectrum measurement conditions without using a window function, a ³¹P-NMR spectrum is obtained. A peak area for the obtained ³¹P-NMR spectrum is calculated using an Integrate function of the above-described measurement and data processing software, and the contents of phosphonoacetic acid and phosphate ions can be calculated from the peak area. For example, in a diphosphoric acid raw material, a ³¹P peak is observed at 6.5 ppm (estimated to be derived from PO₄ from the chemical shift value) and -1.7 ppm (estimated to be derived from P₂O₇ from the chemical shift value). In a phosphoric acid raw material, a ³¹P peak is observed at 6.2 ppm (estimated to be derived from PO₄). Since the chemical shift is shifted depending on a pH or the like of the sample, the calculation is performed in consideration thereof.

In the niobic acid compound dispersion of the present invention, a chlorine content in the niobic acid compound dispersion is preferably 0.0% by mass or more and 2.0% by mass or less in terms of Cl atoms.

The chlorine content in the niobic acid compound dispersion of the present invention is preferably 0.0% by mass or more and 2.0% by mass or less in terms of Cl atoms from a viewpoint of concern about corrosion of a substrate. In addition, the chlorine content is more preferably 0.001% by mass or more and 2.0% by mass or less in terms of Cl atoms, still more preferably 0.001% by mass or more and 0.5% by mass or less in terms of Cl atoms, particularly preferably 0.001% by mass or more and 0.2% by mass or less in terms of Cl atoms, and more particularly preferably 0.001% by mass or more and 0.1% by mass or less in terms of Cl atoms.

The chlorine content in the niobic acid compound dispersion of the present invention is calculated by appropriately diluting the dispersion with dilute hydrochloric acid as necessary, and measuring % by mass of Cl in terms of Cl atoms in accordance with JIS K0116:2014 using ICP emission spectrometry (AG-5110 manufactured by Agilent Technologies). At this time, by subtracting a chlorine content derived from dilute hydrochloric acid used for dilution, the chlorine content in the niobic acid compound dispersion of the present invention can be determined.

Furthermore, in the niobic acid compound dispersion of the present invention, the total content of the phosphorus content in terms of P atoms and the chlorine content in terms of Cl atoms in the niobic acid compound dispersion is preferably 0.01% by mass or more and 10% by mass or less.

The total content in the niobic acid compound dispersion of the present invention is preferably 0.01% by mass or more and 10% by mass or less from a viewpoint of improving dispersibility and solubility in a polar solvent, particularly water. In addition, the total content is more preferably 0.01% by mass or more and 5% by mass or less, still more preferably 0.05% by mass or more and 2% by mass or less, and particularly preferably 0.05% by mass or more and 1% by mass or less.

The niobic acid compound dispersion of the present invention is characterized in that a molar ratio M/Nb of the total amount (M) of the elements X to niobium (Nb) in the niobic acid compound dispersion is 0.01 or more and 10 or less.

The molar ratio M/Nb of the total amount (M) of the elements X to niobium (Nb) in the niobic acid compound dispersion of the present invention is preferably 0.01 or more and 10 or less from a viewpoint of improving dispersibility and solubility in water. The molar ratio M/Nb is more preferably 0.1 or more and 10 or less, still more preferably 1 or more and 9 or less, and particularly preferably 1 or more and 7 or less. Note that the molar ratio M/Nb of the total amount (M) of the elements X to niobium (Nb) in the niobic acid compound dispersion of the present invention may be 0.1 or more and 9 or less, or 0.1 or more and 7 or less.

The niobic acid compound dispersion of the present invention is characterized in that the element X in the niobic acid compound dispersion is Li, and a molar ratio Li/Nb of lithium (Li) to niobium (Nb) is 0.01 or more and 10 or less.

Preferably, the element X in the niobic acid compound dispersion of the present invention is Li, and the molar ratio Li/Nb of lithium (Li) to niobium (Nb) is 0.01 or more and 10 or less from a viewpoint of improving dispersibility and solubility in water. The molar ratio Li/Nb is more preferably 1 or more and 9 or less, and still more preferably 1 or more and 7 or less. Note that the element X in the niobic acid compound dispersion of the present invention may be Li, and the molar ratio Li/Nb of lithium (Li) to niobium (Nb) may be 0.1 or more and 9 or less, or 0.1 or more and 7 or less.

The niobic acid compound dispersion of the present invention is characterized in that a molar ratio M/(P+Cl) of the total amount (M) of the elements X to the total amount (P+Cl) of the phosphorus compound and/or the chlorine compound in the niobic acid compound dispersion is 0.01 or more and 10 or less.

The molar ratio M/(P+Cl) of the total amount (M) of the elements X to the total amount (P+Cl) of the phosphorus compound and/or the chlorine compound in the niobic acid compound dispersion of the present invention is preferably 0.01 or more and 10 or less from a viewpoint of improving dispersibility and solubility in water. The molar ratio M/(P+Cl) is more preferably 0.05 or more and 8 or less, still more preferably 0.05 or more and 7 or less, particularly preferably 0.07 or more and 5 or less, more particularly preferably 0.1 or more and 4 or less, still more particularly preferably 0.1 or more and 3 or less, further still more particularly preferably 0.1 or more and 2 or less, and further still more particularly preferably 0.4 or more and 1.9 or less. Note that, in the present specification, unless otherwise specified, the total amount (P+Cl) of the phosphorus compound and/or the chlorine compound is a sum of a value (P) determined in terms of P atoms and a value (Cl) determined in terms of Cl atoms. In addition, when the niobic acid compound dispersion of the present invention is used for coating a lithium ion secondary battery positive electrode or a positive electrode material described later, the total amount (P+Cl) of the phosphorus compound and/or the chlorine compound preferably satisfies Cl = 0.

Furthermore, in the niobic acid compound dispersion of the present invention, a molar ratio M/P of the total amount (M) of the elements X to the total amount (P) of the phosphorus compounds in the niobic acid compound dispersion is more preferably 0.01 or more and 5 or less.

The molar ratio M/P of the total amount (M) of the elements X to the total amount (P) of the phosphorus compounds in the niobic acid compound dispersion of the present invention is preferably 0.01 or more and 5 or less from a viewpoint of improving dispersibility and solubility in water. The molar ratio M/P is more preferably 0.01 or more and 2 or less, still more preferably 0.05 or more and 2 or less, and particularly preferably 0.1 or more and 1.95 or less.

The niobic acid compound dispersion of the present invention is characterized in that the element X in the niobic acid compound dispersion is Li, and a molar ratio Li/(P+Cl) of lithium (Li) to the total amount (P+Cl) of the phosphorus compound and/or the chlorine compound is 0.01 or more and 10 or less.

Preferably, the element X in the niobic acid compound dispersion of the present invention is Li, and the molar ratio Li/(P+Cl) of lithium (Li) to the total amount (P+Cl) of the phosphorus compound and/or the chlorine compound is 0.01 or more and 10 or less from a viewpoint of improving dispersibility and solubility in water. The molar ratio Li/(P+Cl) is more preferably 0.05 or more and 8 or less, still more preferably 0.05 or more and 7 or less, particularly preferably 0.07 or more and 5 or less, more particularly preferably 0.1 or more and 4 or less, still more particularly preferably 0.1 or more and 3 or less, further still more particularly preferably 0.1 or more and 2 or less, and further still more particularly preferably 0.4 or more and 1.9 or less.

Furthermore, in the niobic acid compound dispersion of the present invention, more preferably, the element X in the niobic acid compound dispersion is Li, and a molar ratio Li/P of lithium (Li) to the total amount (P) of the phosphorus compounds is 0.01 or more and 5 or less.

Preferably, the element X in the niobic acid compound dispersion of the present invention is Li, and the molar ratio Li/P of lithium (Li) to the total amount (P) of the phosphorus compounds is 0.01 or more and 5 or less from a viewpoint of improving dispersibility and solubility in water. The molar ratio Li/P is more preferably 0.01 or more and 2 or less, still more preferably 0.05 or more and 2 or less, and particularly preferably 0.1 or more and 1.95 or less.

The niobic acid compound dispersion of the present invention is characterized in that a molar ratio Nb/(P+Cl) of niobium (Nb) to the total amount (P+Cl) of the phosphorus compound and/or the chlorine compound in the niobic acid compound dispersion is 0.01 or more and 10 or less.

The molar ratio Nb/(P+Cl) of niobium (Nb) to the total amount (P+Cl) of the phosphorus compound and/or the chlorine compound in the niobic acid compound dispersion of the present invention is preferably 0.01 or more and 10 or less from a viewpoint of improving dispersibility and solubility in water. The molar ratio Nb/(P+Cl) is preferably 0.1 or more and 5 or less, still more preferably 0.1 or more and 1 or less, and particularly preferably 0.1 or more and 0.4 or less.

Furthermore, in the niobic acid compound dispersion of the present invention, a molar ratio Nb/P of niobium (Nb) to the total amount (P) of the phosphorus compounds in the niobic acid compound dispersion is more preferably 0.01 or more and 10 or less.

The molar ratio Nb/P of niobium (Nb) to the total amount (P) of the phosphorus compounds in the niobic acid compound dispersion of the present invention is preferably 0.01 or more and 10 or less from a viewpoint of improving dispersibility and solubility in water. The molar ratio Nb/P is more preferably 0.05 or more and 5 or less, still more preferably 0.1 or more and 3 or less, and particularly preferably 0.1 or more and 1.95 or less.

The niobic acid compound dispersion of the present invention is characterized by being an aqueous dispersion.

Since the niobic acid compound in the niobic acid compound dispersion of the present invention has high dispersibility in water and favorable solubility in water, pure water can be used as a solvent. As the solvent, an organic solvent may be used. Examples of the organic solvent include an alcohol solvent, a ketone solvent, an ether solvent, an ester solvent, an aromatic hydrocarbon solvent, and an aliphatic hydrocarbon solvent, and the organic solvent may be a solvent obtained by mixing these organic solvents with pure water. Examples of the alcohol solvent include an alcohol having 5 or less carbon atoms (methanol, ethanol, n-propanol, isopropyl alcohol, butanol, ethylene glycol, or propylene glycol), a high boiling point solvent, and acetone. The above-described solvent and water are preferably compatible. The niobic acid compound dispersion of the present invention can contain one or more solvents at an arbitrary ratio as long as stability is not inhibited.

Examples of the high boiling point solvent include a polyhydric alcohol-based solvent and a glycol-based solvent. Examples of the polyhydric alcohol-based solvent include glycerin (boiling point: 290°C), 1,6-hexanediol (boiling point: 250°C), and 1,7-heptanediol (boiling point: 259°C). Examples of the glycol-based solvent include ethylene glycol (boiling point: 197.3°C), propylene glycol (boiling point: 188.2°C), diethylene glycol (boiling point: 244.3°C), triethylene glycol (boiling point: 287.4°C), oligoethylene glycol (boiling point: 287°C to 460°C), polyethylene glycol (PEG) (boiling point: 460°C or higher), a polyethylene glycol (PEG)-polypropylene glycol (PPG) copolymer (boiling point: 460°C or higher), diethylene glycol monohexyl ether (boiling point: 260°C), a polyoxyalkylene monoalkyl ether (boiling point: 260°C or higher), polyoxyethylene sorbitan monolaurate (boiling point: 321°C or higher), an anionic fluorine-based surfactant (boiling point: 180°C or higher), an amphoteric fluorine-based surfactant (boiling point: 180°C or higher), a nonionic fluorine-based surfactant (boiling point: 180°C or higher), and an amine oxide (boiling point: 180°C or higher). The above-described boiling points are boiling points at 1 atm.

The niobic acid compound dispersion of the present invention is characterized in that a pH of the niobic acid compound dispersion is 2 or more and 11 or less.

The pH of the niobic acid compound dispersion of the present invention is preferably 2 or more and 11 or less from a viewpoint that polyacid ions contained in the dispersion are stabilized. The niobic acid compound dispersion of the present invention may be preferably an acidic niobic acid compound dispersion, may be preferably a neutral niobic acid compound dispersion, or may be preferably a basic niobic acid compound dispersion depending on an application. Note that, in the present specification, unless otherwise specified, "pH" refers to both "initial pH" which is a pH of the niobic acid compound dispersion of the present invention adjusted to a liquid temperature of 25°C immediately after generation, and "temporal pH" which is a pH of the niobic acid compound dispersion after the niobic acid compound dispersion is allowed to stand in a thermostat set at a room temperature of 25°C for one month from the day on which the niobic acid compound dispersion of the present invention is generated.

When an acidic niobic acid compound dispersion is preferable, the pH of the niobic acid compound dispersion of the present invention is preferably less than 7, and preferably 2 or more and less than 7. When a neutral niobic acid compound dispersion is preferable, the pH of the niobic acid compound dispersion of the present invention is preferably 6 or more and 8 or less, and more preferably 7. Furthermore, when a basic niobic acid compound dispersion is preferable, the pH of the niobic acid compound dispersion of the present invention is preferably 7 or more, more preferably 8 or more, still more preferably 9 or more, and particularly preferably 10 or more. On the other hand, the pH is preferably 11 or less. Furthermore, the pH may be 11 or more or 12 or more. Note that the niobic acid compound dispersion of the present invention preferably contains no organic acid because inclusion of the organic acid in the niobic acid compound dispersion of the present invention changes a pH, and a component in the niobic acid compound dispersion of the present invention and the organic acid can interact with each other.

Here, the pH of the niobic acid compound dispersion of the present invention is measured after an electrode (standard ToupH electrode 9615 S-10D manufactured by HORIBA, Ltd.) of a pH meter (glass electrode type hydrogen ion concentration indicator D-51 manufactured by HORIBA, Ltd.) is immersed in the niobic acid compound dispersion of the present invention and it is confirmed that a liquid temperature is stabilized at 25°C.

The niobic acid compound dispersion of the present invention may contain an element that does not constitute a niobic acid compound contained in the niobic acid compound dispersion of the present invention or a compound thereof as an additive. Examples of the additive include elements such as Al, Si, Ti, V, Mn, Fe, Co, Ni, Cu, Zn, Ge, Zr, Ta, Mo, Sn, La, and W, and compounds thereof. Here, examples of the compound include an oxide, a metal acid alkali metal salt, a metal acid alkaline earth metal salt, a chloride, a metal alkoxide, and a polyoxometalate. Regarding the content of the additive in the niobic acid compound dispersion of the present invention, when the total content mol number of elements as the additive is represented by Z, a molar ratio Z/Nb of the total content mol number (Z) of elements as the additive to niobium (Nb) may be 0.001 to 75, 0.002 to 50, 0.01 to 40, 0.2 to 30, 0.5 to 25, 0.8 to 1.5, 0.8 to 1.3, 0.9 to 1.2, or 0.9 to 1.1. The content of each element corresponding to the additive is calculated by measuring % by mass of each element in terms of atoms of each element in a similar manner to the niobium content described above. Furthermore, this is because the niobic acid compound dispersion of the present invention is a uniform dispersion, and therefore improvement of uniformity and improvement of reactivity (reaction rate) are expected even when these compounds are in a suspension state. In addition, if these compounds are dissolved in the niobic acid compound dispersion of the present invention to form a uniform dispersion, a complexing element can have the most favorable reactivity.

Furthermore, the niobic acid compound dispersion of the present invention may contain a component (referred to as "another component") other than a component derived from niobium or niobium acid, ammonia, an organic nitrogen compound, and a component derived from the element X as long as action and effect thereof are not inhibited. Examples of the other component include Al, Si, Ti, V, Mn, Fe, Co, Ni, Cu, Zn, Ge, Zr, Ta, Mo, Sn, La, and W. Note that the other component is not limited thereto. When the content of the niobic acid compound dispersion of the present invention is 100% by mass, the content of the other component is preferably 5% by mass or less, more preferably 4% by mass or less, and still more preferably 3% by mass or less. The content of each element corresponding to the other component is calculated by measuring % by mass of each element in terms of each element atoms in a similar manner to the niobium content described above. Note that the niobic acid compound dispersion of the present invention is assumed to contain inevitable impurities which are not intended. The content of the inevitable impurities is preferably 0.01% by mass or less.

A niobic acid compound powder of the present invention is characterized by containing the niobic acid compound in the niobic acid compound dispersion of the present invention described above.

The niobic acid compound powder of the present invention includes a dried powder obtained by drying, for example, vacuum drying, the niobic acid compound dispersion of the present invention, and a fired powder obtained by firing the obtained dried powder. The niobic acid compound powder of the present invention also includes a niobic acid compound powder having different physical properties such as a different crystal structure, which is generated by vacuum drying or firing the niobic acid compound dispersion of the present invention, and may have an amorphous structure, a single crystal structure, or a polycrystalline structure. Note that a method for producing the niobic acid compound powder of the present invention will be described later.

A niobic acid compound film of the present invention is characterized by containing the niobic acid compound in the niobic acid compound dispersion of the present invention described above.

The niobic acid compound film of the present invention includes a dried film obtained by applying the niobic acid compound dispersion of the present invention to a surface of a substrate, and then drying, for example, vacuum drying, the niobic acid compound dispersion, and a fired film obtained by firing the obtained dried film. The niobic acid compound film of the present invention also includes a niobic acid compound film having different physical properties such as a different crystal structure, which is generated by vacuum drying or firing the niobic acid compound dispersion of the present invention, and may have an amorphous structure, a single crystal structure, or a polycrystalline structure. Since the niobium compound which is a raw material of the niobic acid compound film of the present invention has high chemical resistance, by coating a surface of a substrate with the niobic acid compound film of the present invention, high-temperature characteristics (for example, protection of the substrate from deterioration due to heat) and chemical resistance of the substrate can be improved. Note that a method for producing the niobic acid compound film of the present invention will be described later.

A coating agent of the present invention is characterized by containing the niobic acid compound dispersion of the present invention described above.

The coating agent of the present invention contains the niobic acid compound dispersion of the present invention, having high dispersibility in water, favorable solubility in water, and excellent storage stability.

In addition, the coating agent of the present invention is characterized by containing the niobic acid compound powder of the present invention described above.

The coating agent of the present invention contains the niobic acid compound powder of the present invention, having high dispersibility in water, favorable solubility in water, and excellent storage stability.

In addition, the niobic acid compound dispersion of the present invention is characterized by being used for coating a lithium ion secondary battery positive electrode or a positive electrode material.

The niobic acid compound dispersion of the present invention can also be used for coating a lithium ion secondary battery positive electrode or a positive electrode material.

A lithium ion secondary battery positive electrode active material of the present invention is characterized in that a surface thereof is coated with a niobic acid compound contained in the niobic acid compound dispersion of the present invention described above.

Here, specific examples of the lithium ion secondary battery positive electrode active material that can be used include LiMn₂O₄ (manufactured by Merck Corporation: spinel type, particle size < 0.5 µm), LiCoO₂, LiNiO₂, LiFeO₂, Li₂MnO₃, LiFePO₄, LiCoPO₄, LiNiPO₄, LiMnPO₄, LiNi_{0.5}Mn_{1.5}O₄, LiMn_{1/3}Co_{1/3}Ni_{1/3}O₂, LiCo_{0.2}Ni_{0.4}Mn_{0.4}O₂, lithium molybdate, LiMnO₄, LiNi_{0.8}Co_{0.15}Al_{0.05}O₂, and LiMnO₂.

A lithium ion secondary battery of the present invention is characterized by having a positive electrode whose surface is coated with the lithium ion secondary battery positive electrode active material of the present invention described above.

A method for producing the niobic acid compound dispersion of the present invention described above will be described below.

The method for producing a niobic acid compound dispersion of the present invention may include: a reaction step of generating a niobium fluoride aqueous solution; a neutralization reaction step of adding the niobium fluoride aqueous solution to an alkaline aqueous solution containing one or more elements X selected from the group consisting of alkali metal elements and/or alkaline earth metal elements to generate a niobium compound neutralized aqueous solution; and a mixing step of mixing the niobium compound neutralized aqueous solution with a phosphorus compound, a phosphorus compound solution and/or a chlorine compound, or a chlorine compound solution.

First, the niobium fluoride aqueous solution can be prepared by causing niobium, niobium oxide, or niobium hydroxide to react with hydrofluoric acid (HF) such as a hydrofluoric acid aqueous solution to form niobium fluoride (H₂NbF₇), and dissolving the niobium fluoride in water.

Here, the niobium fluoride aqueous solution is preferably adjusted by adding water (for example, pure water) so as to contain 1 to 100 g/L of niobium in terms of Nb₂O₅. At this time, the niobium content is preferably 1 g/L or more in terms of Nb₂O₅ because a niobic acid compound hydrate soluble in water is formed, and the niobium content is more preferably 10 g/L or more, and still more preferably 20 g/L or more in consideration of productivity. On the other hand, the niobium content is preferably 100 g/L or less in terms of Nb₂O₅ because a niobic acid compound hydrate soluble in water is formed, and the niobium content is more preferably 90 g/L or less, still more preferably 80 g/L or less, and particularly preferably 70 g/L or less in order to more reliably synthesize a niobic acid compound hydrate soluble in water. Note that a pH of the niobium fluoride aqueous solution is preferably 2 or less and more preferably 1 or less from a viewpoint of completely dissolving niobium or niobium oxide.

The neutralization reaction step of adding the obtained niobium fluoride aqueous solution to an alkaline aqueous solution containing one or more elements X selected from the group consisting of alkali metal elements and/or alkaline earth metal elements to generate a niobium compound neutralized aqueous solution is as follows.

In the neutralization reaction step, first, the obtained niobium fluoride aqueous solution is added to ammonia water, that is, by a reverse neutralization method, a niobium-containing precipitation slurry is obtained. Then, by removing fluoride ions from the obtained niobium-containing precipitation slurry, a niobium-containing precipitate from which fluoride ions have been removed is obtained.

The ammonia water used for the reverse neutralization preferably has an ammonia content of 10% by mass to 30% by mass. When the ammonia content is 10% by mass, niobium hardly remains undissolved, and niobium or niobic acid can be completely dissolved in water. On the other hand, the ammonia content is preferably 30% by mass or less because the ammonia water having the content is in the vicinity of a saturated aqueous solution of ammonia.

From such a viewpoint, the ammonia content of the ammonia water is preferably 10% by mass or more, more preferably 15% by mass or more, still more preferably 20% by mass or more, and particularly preferably 25% by mass. On the other hand, the ammonia content is preferably 30% by mass or less, more preferably 29% by mass or less, and still more preferably 28% by mass or less.

Regarding the addition amount of the niobium fluoride aqueous solution to be added to the ammonia water, a molar ratio of NH₃/Nb₂O₅ is preferably 95 or more and 500 or less, more preferably 100 or more and 450 or less, and still more preferably 110 or more and 400 or less. In addition, regarding the addition amount of the niobium fluoride aqueous solution to be added to the ammonia water, a molar ratio of NH₃/HF is preferably 3.0 or more, more preferably 4.0 or more, and still more preferably 5.0 or more from a viewpoint of generating a niobic acid compound soluble in an amine or thin ammonia water. On the other hand, the molar ratio of NH₃/HF is preferably 100 or less, more preferably 50 or more, and still more preferably 40 or more from a viewpoint of cost reduction.

A time required for adding the niobium fluoride aqueous solution to the ammonia water is preferably one minute or less, more preferably 30 seconds or less, and still more preferably 10 seconds or less. That is, suitably, the niobium fluoride aqueous solution is put into the ammonia water in as short a time as possible, for example, the niobium fluoride aqueous solution is put at once, and subjected to a neutralization reaction without being gradually added over time. In the reverse neutralization step, since the acidic niobium fluoride aqueous solution is added to the alkaline ammonia water, the neutralization reaction can be performed while a high pH is maintained. Note that the niobium fluoride aqueous solution and the ammonia water can be used at room temperature.

Then, fluoride ions are removed from the niobium-containing precipitation slurry obtained by the reverse neutralization method, and a niobium-containing precipitate from which fluoride ions have been removed can be obtained. Since a fluorine compound such as ammonium fluoride is present as an impurity in the niobium-containing precipitation slurry obtained by the reverse neutralization method, it is preferable to remove the fluorine compound.

Any method for removing the fluorine compound can be used, and for example, a method by filtration using a film, such as reverse osmosis filtration, ultrafiltration, or microfiltration using ammonia water or pure water, centrifugation, or other known methods can be adopted. Note that, when the fluoride ions are removed from the niobium-containing precipitation slurry, temperature adjustment is not particularly necessary, and the removal may be performed at room temperature.

Specifically, the niobium-containing precipitation slurry obtained by the reverse neutralization method is decanted using a centrifuge, and cleaning is repeated until the amount of released fluoride ions is 100 mg/L or less, thereby obtaining a niobium-containing precipitate from which fluoride ions have been removed.

A cleaning liquid used for removing the fluoride ions is suitably ammonia water. Specifically, ammonia water having a concentration of 5.0% by mass or less is preferable, ammonia water having a concentration of 4.0% by mass or less is more preferable, ammonia water having a concentration of 3.0% by mass or less is still more preferable, and ammonia water having a concentration of 2.5% by mass is particularly preferable. When ammonia water having a concentration of 5.0% by mass or less is used, ammonia containing ammonium ions is appropriate for fluoride ions, and an unnecessary increase in cost can be avoided.

The niobium-containing precipitate from which fluoride ions have been removed, thus obtained is diluted with pure water or the like, thereby obtaining a niobium-containing precipitation slurry from which fluoride ions have been removed. Note that, regarding the niobium content of the niobium-containing precipitation slurry, a part of the slurry is collected, dried at 110°C for 24 hours, and then fired at 1000°C for four hours to generate Nb₂O₅. The weight of Nb₂O₅ thus generated is measured, and the niobium content of the slurry can be calculated from the weight.

Next, in the neutralization reaction step, a niobium-containing precipitation slurry from which fluoride ions generated have been removed is obtained. Then, a mixture obtained by mixing the niobium-containing precipitation slurry from which fluoride ions have been removed, a hydroxide of the element X, for example, lithium hydroxide monohydrate, and pure water is kept at 20°C to 100°C for 0.1 hours to 72 hours while being stirred, thereby obtaining a niobium compound neutralized aqueous solution.

The mixing step of mixing the obtained niobium compound neutralized aqueous solution with a phosphorus compound, a phosphorus compound solution and/or a chlorine compound, or a chlorine compound solution is as follows.

In the mixing step, a phosphorus compound, a phosphorus compound solution and/or a chlorine compound, or a chlorine compound solution is added to the obtained niobium compound neutralized aqueous solution, and the resulting mixture is mixed at room temperature for 0.1 hours to two hours, thereby obtaining the niobic acid compound dispersion of the present invention.

Here, the phosphorus compound preferably contains one or more selected from an inorganic phosphorus compound, an organic phosphorus compound, and a salt thereof.

Furthermore, as the phosphorus compound, one or more selected from condensed phosphoric acid, pyrophosphoric acid (CAS No. 2466-09-3), polyphosphoric acid (CAS No. 8071-16-1), phosphorous acid (CAS No. 13598-36-2), hypophosphorous acid (CAS No. 6303-21-5), ammonium phosphate, primary ammonium phosphate (CAS No. 7722-76-1), secondary ammonium phosphate (CAS No. 7783-28-0), ammonium pyrophosphate, and ammonium polyphosphate are preferably contained.

In addition, a phosphorus compound solution whose concentration is adjusted such that the phosphorus content in the niobic acid compound dispersion of the present invention is 0.01% by mass or more and 10% by mass or less in terms of P atoms by adding pure water to the phosphorus compound described above may be used.

Here, examples of the chlorine compound include hydrochloric acid (CAS number: 7647-01-0), hypochlorous acid (CAS number: 7790-92-3), chlorous acid (CAS number: 13898-47-0), chloric acid (CAS number: 7790-93-4), and perchloric acid (CAS number: 7601-90-3).

The chlorine compound may be a salt of the chlorine compound described above, and examples thereof include an ammonium salt, an amine salt, a quaternary ammonium salt, and a lithium salt. The chlorine compound is preferably an ammonium salt or a lithium salt. Specific examples thereof include ammonium chloride (CAS No. 12125-02-9), ammonium perchlorate (CAS No. 7790-98-9), lithium chloride (CAS No. 7447-41-8), lithium perchlorate (CAS No. 7791-03-9), methylamine hydrochloride (CAS No. 593-51-1), and dimethylamine hydrochloride (CAS No. 506-59-2).

In addition, a chlorine compound solution whose concentration is adjusted such that the chlorine content in the niobic acid compound dispersion of the present invention is 0.0% by mass or more and 2.0% by mass or less in terms of Cl atoms by adding pure water to the chlorine compound described above may be used.

In the method for producing a niobic acid compound dispersion of the present invention, in the mixing step, a phosphorus compound mixed solution and/or a chlorine compound mixed solution generated by mixing the phosphorus compound, the phosphorus compound solution and/or the chlorine compound, or the chlorine compound solution with the element X in advance may be mixed with the niobium compound neutralized aqueous solution.

In the mixing step in the method for producing a niobic acid compound dispersion of the present invention, in a previous step of adding a phosphorus compound, a phosphorus compound solution and/or a chlorine compound, or a chlorine compound solution to a niobium compound neutralized aqueous solution, the phosphorus compound, the phosphorus compound solution and/or the chlorine compound, or the chlorine compound solution may be mixed in advance with one or more elements X selected from the group consisting of alkali metal elements and/or alkaline earth metal elements, thereby obtaining a phosphorus compound mixed solution and/or a chlorine compound mixed solution.

Examples of the one or more elements X selected from the group consisting of alkali metal elements and/or alkaline earth metal elements, to be mixed in advance with the phosphorus compound, the phosphorus compound solution and/or the chlorine compound, or the chlorine compound solution include lithium hydroxide monohydrate.

In order to remove an ammonia component contained in the obtained niobic acid compound dispersion of the present invention, the following concentration adjusting step may be performed. In the concentration adjusting step, for example, the niobic acid compound dispersion is heated and stirred at 60°C to 90°C for one hour to 100 hours, and then cooled to room temperature. Thereafter, a solvent (pure water or the like) is added in order to replenish an evaporated solvent (pure water or the like). The addition amount of the solvent is adjusted such that the niobium content of the niobic acid compound dispersion of the present invention after removal of the ammonia component coincides with the niobium content of the niobic acid compound dispersion of the present invention before removal of the ammonia component.

Specifically, a phosphorus compound, a phosphorus compound solution and/or a chlorine compound, or a chlorine compound solution is mixed with the obtained niobium compound neutralized aqueous solution such that the niobium content of a final mixture is 0.01% by mass or more and 30% by mass or less in terms of Nb atoms, and the resulting mixture is stirred, thereby obtaining the niobic acid compound dispersion of the present invention. A composition ratio of each component in the niobic acid compound dispersion of the present invention thus obtained is preferably as follows.

When the element X contained in the niobic acid compound dispersion of the present invention is Li, a molar ratio Li/(P+Cl) of lithium (Li) to the total amount (P+Cl) of a phosphorus compound and/or a chlorine compound is preferably 0.01 or more and 10 or less from a viewpoint of improving dispersibility and solubility in water. The molar ratio Li/(P+Cl) is more preferably 0.05 or more and 8 or less, still more preferably 0.05 or more and 7 or less, particularly preferably 0.07 or more and 5 or less, more particularly preferably 0.1 or more and 4 or less, still more particularly preferably 0.1 or more and 3 or less, further still more particularly preferably 0.1 or more and 2 or less, and further still more particularly preferably 0.4 or more and 1.9 or less. Also when the element X contained in the niobic acid compound dispersion of the present invention is an element X selected from alkali metal elements other than lithium and/or alkaline earth metal elements, a molar ratio M/(P+Cl) of the total amount (M) of the elements X to the total amount (P+Cl) of a phosphorus compound and/or a chlorine compound is preferably 0.01 or more and 10 or less from a viewpoint of improving dispersibility and solubility in water. The molar ratio M/(P+Cl) is more preferably 0.05 or more and 8 or less, still more preferably 0.05 or more and 7 or less, particularly preferably 0.07 or more and 5 or less, more particularly preferably 0.1 or more and 4 or less, still more particularly preferably 0.1 or more and 3 or less, further still more particularly preferably 0.1 or more and 2 or less, and further still more particularly preferably 0.4 or more and 1.9 or less. Note that a case where the element X contains a plurality of elements of lithium and another alkali metal element and/or an alkaline earth metal element, and a case where the element X contains a plurality of elements selected from alkali metal elements other than lithium and/or alkaline earth metals are included.

When the element X contained in the niobic acid compound dispersion of the present invention is Li, a molar ratio Li/P of lithium (Li) to the total amount (P) of phosphorus compounds is preferably 0.01 or more and 10 or less from a viewpoint of improving dispersibility and solubility in water. The molar ratio Li/P is more preferably 0.05 or more and 8 or less, still more preferably 0.05 or more and 7 or less, particularly preferably 0.07 or more and 5 or less, more particularly preferably 0.1 or more and 4 or less, still more particularly preferably 0.1 or more and 3 or less, further still more particularly preferably 0.1 or more and 2 or less, and further still more particularly preferably 0.4 or more and 1.9 or less. Also when the element X contained in the niobic acid compound dispersion of the present invention is an element X selected from alkali metal elements other than lithium and/or alkaline earth metal elements, a molar ratio M/P of the total amount (M) of the elements X to the total amount (P) of phosphorus compounds is preferably 0.01 or more and 10 or less from a viewpoint of improving dispersibility and solubility in water. The molar ratio M/P is more preferably 0.05 or more and 8 or less, still more preferably 0.05 or more and 7 or less, particularly preferably 0.07 or more and 5 or less, more particularly preferably 0.1 or more and 4 or less, still more particularly preferably 0.1 or more and 3 or less, further still more particularly preferably 0.1 or more and 2 or less, and further still more particularly preferably 0.4 or more and 1.9 or less.

Furthermore, a molar ratio Nb/(P+Cl) of niobium (Nb) to the total amount (P+Cl) of a phosphorus compound and/or a chlorine compound contained in the niobic acid compound dispersion of the present invention is preferably 0.01 or more and 10 or less from a viewpoint of improving dispersibility and solubility in water. The molar ratio Nb/(P+Cl) is preferably 0.1 or more and 5 or less, still more preferably 0.1 or more and 1 or less, and particularly preferably 0.1 or more and 0.4 or less.

Furthermore, a molar ratio Nb/P of niobium (Nb) to the total amount (P) of phosphorus compounds contained in the niobic acid compound dispersion of the present invention is preferably 0.01 or more and 10 or less from a viewpoint of improving dispersibility and solubility in water. The molar ratio Nb/P is more preferably 0.1 or more and 5 or less, still more preferably 0.1 or more and 1 or less, and particularly preferably 0.1 or more and 0.4 or less.

When the element X contained in the niobic acid compound dispersion of the present invention is Li, a molar ratio Li/Nb of lithium (Li) to niobium (Nb) is preferably 0.01 or more and 10 or less from a viewpoint of improving dispersibility and solubility in water. The molar ratio Li/Nb is more preferably 1 or more and 9 or less, and still more preferably 1 or more and 7 or less. Also when the element X contained in the niobic acid compound dispersion of the present invention is an element X selected from alkali metal elements other than lithium and/or alkaline earth metal elements, a molar ratio M/Nb of the total amount (M) of the elements X to niobium (Nb) is preferably 0.01 or more and 10 or less from a viewpoint of improving dispersibility and solubility in water. The molar ratio M/Nb is more preferably 0.1 or more and 10 or less, still more preferably 1 or more and 9 or less, and particularly preferably 1 or more and 7 or less. Note that a case where the element X contains a plurality of elements of lithium and another alkali metal element and/or an alkaline earth metal element, and a case where the element X contains a plurality of elements selected from alkali metal elements other than lithium and/or alkaline earth metals are included.

Another example of the method for producing a niobic acid compound dispersion of the present invention may include: a reaction step of generating a niobium fluoride aqueous solution; a neutralization reaction step of adding the niobium fluoride aqueous solution to an alkaline aqueous solution containing an organic nitrogen compound to generate a niobium compound neutralized aqueous solution; and a mixing step of adding, to the niobium compound neutralized aqueous solution, a phosphorus compound mixed solution and/or a chlorine compound mixed solution generated by mixing a phosphorus compound, a phosphorus compound solution and/or a chlorine compound, or a chlorine compound solution with one or more elements X selected from the group consisting of alkali metal elements and/or alkaline earth metal elements, and mixing the mixture.

Here, in the other example of the method for producing a niobic acid compound dispersion of the present invention, the steps until a niobium-containing precipitation slurry from which fluoride ions have been removed is obtained are similar to those in the method for producing a niobic acid compound dispersion of the present invention described above, and thus detailed description thereof is omitted.

In a similar manner to the method for producing a niobic acid compound dispersion of the present invention described above, a mixture obtained by mixing the obtained niobium-containing precipitation slurry from which fluoride ions have been removed, an organic nitrogen compound, and pure water is kept at 5°C to 90°C for 0.1 hours to 48 hours while being stirred, thereby obtaining a niobium compound neutralized aqueous solution.

As described above, the organic nitrogen compound to be mixed with the niobium-containing precipitation slurry is preferably an aliphatic amine, an aromatic amine, an amino alcohol, an amino acid, a polyamine, a quaternary ammonium, a guanidine compound, or an azole compound, and particularly more preferably an aliphatic amine and/or a quaternary ammonium compound.

The aliphatic amine is preferably mixed such that the content of the aliphatic amine in the niobium-containing precipitation slurry is 40% by mass or less, and the content is more preferably 20% by mass or less from a viewpoint of solubility. From a similar viewpoint, the aliphatic amine is preferably mixed such that the content of the aliphatic amine in the niobium-containing precipitation slurry is 0.1% by mass or more, more preferably 1% by mass or more, and the content may be 5% by mass or more or 10% by mass or more. Note that the aliphatic amine is more preferably methylamine or dimethylamine.

The quaternary ammonium compound is preferably mixed such that the content of the quaternary ammonium compound in the niobium-containing precipitation slurry is 40% by mass or less, and the content is more preferably 20% by mass or less from a viewpoint of solubility. From a similar viewpoint, the quaternary ammonium compound is preferably mixed such that the content of the quaternary ammonium compound in the niobium-containing precipitation slurry is 0.1% by mass or more, more preferably 1% by mass or more, and the content may be 5% by mass or more or 10% by mass or more. Note that the quaternary ammonium compound is more preferably tetramethylammonium hydroxide (TMAH) or tetraethylammonium hydroxide (TEAH).

In the mixing step in the other example of the method for producing a niobic acid compound dispersion of the present invention, to the obtained niobium compound neutralized aqueous solution, a phosphorus compound mixed solution and/or a chlorine compound mixed solution generated by mixing a phosphorus compound, a phosphorus compound solution and/or a chlorine compound, or a chlorine compound solution with one or more elements X selected from the group consisting of alkali metal elements and/or alkaline earth metal elements is added, and the mixture is mixed.

The phosphorus compound mixed solution is generated by mixing a phosphorus compound or a phosphorus compound solution with one or more elements X selected from the group consisting of alkali metal elements and/or alkaline earth metal elements in advance.

Here, the phosphorus compound preferably contains one or more selected from an inorganic phosphorus compound, an organic phosphorus compound, and a salt thereof.

Furthermore, as the phosphorus compound, one or more selected from phosphoric acid (CAS No. 7664-38-2), condensed phosphoric acid, pyrophosphoric acid (CAS No. 2466-09-3), polyphosphoric acid (CAS No. 8071-16-1), phosphorous acid (CAS No. 13598-36-2), hypophosphorous acid (CAS No. 6303-21-5), ammonium phosphate, primary ammonium phosphate (CAS No. 7722-76-1), secondary ammonium phosphate (CAS No. 7783-28-0), ammonium pyrophosphate, and ammonium polyphosphate are preferably contained.

In addition, a phosphorus compound solution whose concentration is adjusted such that the phosphorus content in the niobic acid compound dispersion of the present invention is 0.01% by mass or more and 10% by mass or less in terms of P atoms by adding pure water to the phosphorus compound described above may be used.

The chlorine compound mixed solution is generated by mixing a chlorine compound or a chlorine compound solution with one or more elements X selected from the group consisting of alkali metal elements and/or alkaline earth metal elements in advance.

Here, examples of the chlorine compound include hydrochloric acid (CAS number: 7647-01-0), hypochlorous acid (CAS number: 7790-92-3), chlorous acid (CAS number: 13898-47-0), chloric acid (CAS number: 7790-93-4), and perchloric acid (CAS number: 7601-90-3).

The chlorine compound may be a salt of the chlorine compound described above, and examples thereof include an ammonium salt, an amine salt, a quaternary ammonium salt, and a lithium salt. The chlorine compound is preferably an ammonium salt or a lithium salt. Specific examples thereof include ammonium chloride (CAS No. 12125-02-9), ammonium perchlorate (CAS No. 7790-98-9), lithium chloride (CAS No. 7447-41-8), lithium perchlorate (CAS No. 7791-03-9), methylamine hydrochloride (CAS No. 593-51-1), and dimethylamine hydrochloride (CAS No. 506-59-2).

In addition, a chlorine compound solution whose concentration is adjusted such that the chlorine content in the niobic acid compound dispersion of the present invention is 0.0% by mass or more and 2.0% by mass or less in terms of Cl atoms by adding pure water to the chlorine compound described above may be used.

Examples of the one or more elements X selected from the group consisting of alkali metal elements and/or alkaline earth metal elements, to be mixed in advance with the phosphorus compound, the phosphorus compound solution and/or the chlorine compound, or the chlorine compound solution include lithium hydroxide monohydrate.

The order of adding the niobium compound neutralized aqueous solution, the phosphorus compound, the phosphorus compound solution and/or the chlorine compound, or the chlorine compound solution, the one or more elements X selected from the group consisting of alkali metal elements and/or alkaline earth metal elements, pure water, and the like, to be mixed in the mixing step of the method for producing a niobic acid compound dispersion of the present invention, is not limited to the above-described order, and can be appropriately changed.

A method for producing a niobic acid compound powder containing the niobic acid compound in the niobic acid compound dispersion of the present invention will be described below.

In a method for producing a niobic acid compound dried powder among the niobic acid compound powders, the niobic acid compound dispersion obtained by the above-described method for producing a niobic acid compound dispersion of the present invention is placed in a stationary furnace, and dried, for example, vacuum-dried at a heating temperature of about 60°C to 200°C for one hour to 72 hours, whereby moisture of the niobic acid compound dispersion of the present invention is evaporated, thereby obtaining a niobic acid compound dried powder containing niobic acid compound crystal particles contained in the niobic acid compound dispersion of the present invention.

On the other hand, in a method for producing a niobic acid compound fired powder, as described above, the niobic acid compound dispersion of the present invention is vacuum-dried, and the obtained niobic acid compound dried powder is placed in a stationary furnace and fired at a firing temperature of 300°C or higher and 1200°C or lower for a firing time of one hour or more and 72 hours or less in the air, thereby obtaining a niobic acid compound fired powder.

Note that a powder obtained by pulverizing the niobic acid compound dried powder and the niobic acid compound fired powder described above may be used as the niobic acid compound powder. In addition, undersize (fine particle side) particles obtained by classifying the niobic acid compound dried powder and the niobic acid compound fired powder described above with a sieve or the like may be used as the niobic acid compound powder regardless of whether or not the powders are pulverized. Oversize (coarse particle side) particles may be pulverized again, classified, and used. Note that both pulverization and classification can also be performed by using a vibrating sieve into which an iron ball or the like coated with nylon or a fluororesin is put as a pulverizing medium. By performing both classification and pulverization as described above, even if there is an excessively large niobic acid compound powder, the excessively large niobic acid compound powder can be removed. Specifically, when classification is performed using a sieve, it is preferable to use a sieve having a mesh size of 150 µm to 1000 µm. When the mesh size is 150 µm to 1000 µm, a ratio of oversize particles is not too large, re-pulverization is not repeated, and a niobic acid compound powder that needs to be re-pulverized is not classified into undersize particles.

The niobic acid compound powder thus obtained is mixed with water or an organic solvent as a dispersion medium, and wet-pulverized using a medium such as beads, whereby a niobic acid compound powder dispersion can be obtained. Here, examples of the organic solvent used as a dispersion medium include alcohols, esters, ketones, aromatic hydrocarbons, aliphatic hydrocarbons, ethers, and mixed solvents thereof. Furthermore, in order to improve film formability of a niobic acid compound film using the niobic acid compound powder dispersion, a binder such as a resin component may be added. Examples of the resin component used as the binder include an acrylic resin, polyurethane, an epoxy resin, polystyrene, polycarbonate, a glycol-based resin, a cellulose-based resin, a mixed resin thereof, and a copolymer resin.

Furthermore, a method for producing a niobic acid compound film containing the niobic acid compound in the niobic acid compound dispersion of the present invention will be described below.

A method for producing a niobic acid compound dried film among niobic acid compound films includes: an application step of applying a niobic acid compound dispersion to a surface of a substrate; and a film drying step of drying the niobic acid compound dispersion applied to the surface of the substrate to obtain a dried film.

Specifically, the niobic acid compound dispersion obtained by the above-described method for producing a niobic acid compound dispersion of the present invention is dropped onto the surface of the substrate using a syringe while being filtered with, for example, a filter having a pore size of 1 µm as necessary, and applied thereto by spin coating (700 rpm, after 10 seconds, 1500 rpm, 30 seconds). Next, the niobic acid compound dispersion is dried at 110°C for 30 minutes to form a niobic acid compound dried film on the surface of the substrate.

A method for producing a niobic acid compound fired film among niobic acid compound films includes: an application step of applying a niobic acid compound dispersion to a surface of a substrate; a film drying step of drying the niobic acid compound dispersion applied to the surface of the substrate in the air or under vacuum to obtain a dried film; and a film firing step of firing the dried film in the air at a firing temperature of 300°C or higher and 1200°C or lower for a firing time of one hour or more and 12 hours or less to obtain a fired film.

Specifically, as described above, the substrate on which the niobic acid compound dried film obtained by applying the niobic acid compound dispersion to the surface of the substrate and drying the niobic acid compound dispersion is formed is placed in a stationary furnace, and fired in the air at a firing temperature of 300°C or higher and 1200°C or lower for a firing time of one hour or more and 12 hours or less to form a niobic acid compound fired film on the surface of the substrate.

Furthermore, a method for producing a lithium ion secondary battery positive electrode active material coated with a niobic acid compound contained in the niobic acid compound dispersion of the present invention will be described below.

The method includes: a step of mixing the niobic acid compound dispersion of the present invention, a positive electrode active material, and a lithium hydroxide aqueous solution as necessary to generate a battery positive electrode active material slurry containing a niobic acid compound; and a step of drying the battery positive electrode active material slurry containing the niobic acid compound.

First, a battery positive electrode active material, for example, LiMn₂O₄ (manufactured by Merck Corporation: spinel type, particle size < 0.5 µm) is added to a niobic acid compound dispersion obtained by diluting the niobic acid compound dispersion of the present invention with pure water to obtain a slurry containing a niobic acid compound. Then, a lithium hydroxide aqueous solution is dropped thereonto while the slurry containing the niobic acid compound is stirred, and the mixture is held at 90°C for ten minutes, whereby a battery positive electrode active material slurry containing the niobic acid compound is generated.

Next, the battery positive electrode active material slurry containing the niobic acid compound is held at a furnace temperature of 110°C and dried in an air drying furnace for 15 hours, whereby a lithium ion secondary battery positive electrode active material coated with the niobic acid compound can be produced.

Note that, in the present specification, the expression "X to Y" (X and Y are any numbers) includes a meaning of "preferably more than X" or "preferably less than Y" as well as a meaning of "X or more and Y or less" unless otherwise specified. In addition, the expression "X or more" (X is any number) or "Y or less" (Y is any number) includes a meaning of "preferably more than X" or "preferably less than Y".

### Advantageous Effects of Invention

The niobic acid compound dispersion of the present invention has high dispersibility in a polar solvent, particularly water, has favorable solubility in water, and excellent storage stability. In addition, the method for producing a niobic acid compound dispersion of the present invention can produce a niobic acid compound dispersion having high dispersibility in a polar solvent, particularly water, favorable solubility in water, and excellent storage stability.

### Brief Description of Drawings

Fig. 1 is a list of physical property values of niobic acid compound dispersions according to Examples 1 to 10 of the present invention and Comparative Examples 1 to 3.
Fig. 2 is a list of measurement results of niobic acid compound dispersions according to Examples 1 to 10 of the present invention and Comparative Examples 1 to 3.

### Best Mode for Carrying Out the Invention

Hereinafter, a niobic acid compound dispersion of an embodiment according to the present invention will be further described with reference to the following Examples. Note that the following Examples do not limit the present invention.

### (Example 1)

Into a polypropylene container, 0.3 g of pyrophosphoric acid (manufactured by FUJIFILM Wako Pure Chemical Corporation, product name: diphosphoric acid (containing phosphoric acid), CAS number: 2466-09-3) and 28.5 g of pure water were put, and 0.84 g of a 5% by mass lithium hydroxide monohydrate aqueous solution was added to the obtained phosphorus compound aqueous solution to obtain a phosphorus compound mixed solution.

Here, the 5% by mass lithium hydroxide monohydrate aqueous solution was obtained by mixing 15 g of LiOH•H₂O and 285 g of pure water.

Then, 2.93 g of a niobium compound neutralized aqueous solution described later was added to the phosphorus compound mixed solution, and the mixture was stirred for 30 minutes and mixed to obtain a niobic acid compound dispersion according to Example 1.

Here, the niobium compound neutralized aqueous solution according to Example 1 was obtained as follows.

In 200 g of a 55% hydrofluoric acid aqueous solution, 100 g of niobium pentoxide was dissolved, and 830 mL of pure water was added thereto to obtain a niobium fluoride aqueous solution containing 100 g/L of niobium in terms of Nb₂O₅ (Nb₂O₅ = 8.85% by mass). To 1 L of ammonia water (NH₃ concentration: 25% by mass), 200 mL of this niobium fluoride aqueous solution was added in a time shorter than one minute (NH₃/Nb₂O₅ molar ratio = 176.9, NH₃/HF molar ratio = 12.1) to obtain a reaction liquid (pH 11). This reaction liquid was a slurry of a niobic acid compound hydrate, in other words, a slurry of a niobium-containing precipitate.

Next, this reaction liquid was decanted using a centrifuge, and cleaned until the amount of released fluoride ions reached 100 mg/L or less to obtain a niobium-containing precipitate from which the fluoride ions had been removed. At this time, ammonia water was used as the cleaning liquid.

Furthermore, the niobium-containing precipitate from which the fluoride ions had been removed was diluted with pure water to obtain a slurry. A part of this slurry was dried at 110°C for 24 hours and then fired at 1000°C for four hours to generate Nb₂O₅, and the content of Nb₂O₅ contained in the slurry was calculated from the weight of Nb₂O₅.

Then, the niobium-containing precipitation slurry diluted with pure water, 5% by mass lithium hydroxide, and pure water were mixed to obtain a translucent slurry mixture. This mixture was held for one hour such that a liquid temperature was 50°C to 100°C, for example, 70°C while being stirred, thereby obtaining a niobium compound neutralized aqueous solution according to Example 1. The niobium content was 2.86% by mass, and the lithium content was 0.23% by mass in the niobium compound neutralized aqueous solution according to Example 1.

### (Example 2)

In Example 2, into a polypropylene container, 0.29 g of pyrophosphoric acid and 26.85 g of pure water were put, and 2.85 g of a 5% by mass lithium hydroxide monohydrate aqueous solution was added to the obtained phosphorus compound aqueous solution to obtain a phosphorus compound mixed solution.

Then, 3.02 g of the niobium compound neutralized aqueous solution used in Example 1 was added to the phosphorus compound mixed solution, and the mixture was stirred for 30 minutes and mixed to obtain a niobic acid compound dispersion according to Example 2.

Note that the pyrophosphoric acid and the 5% by mass lithium hydroxide monohydrate aqueous solution used in Example 2 were the same as those in Example 1.

### (Example 3)

In Example 3, into a polypropylene container, 0.29 g of pyrophosphoric acid and 25.51 g of pure water were put, and 4.22 g of a 5% by mass lithium hydroxide monohydrate aqueous solution was added to the obtained phosphorus compound aqueous solution to obtain a phosphorus compound mixed solution.

Then, 2.96 g of the niobium compound neutralized aqueous solution used in Example 1 was added to the phosphorus compound mixed solution, and the mixture was stirred for 30 minutes and mixed to obtain a niobic acid compound dispersion according to Example 3.

Note that the pyrophosphoric acid and the 5% by mass lithium hydroxide monohydrate aqueous solution used in Example 3 were the same as those in Example 1.

### (Example 4)

In Example 4, into a polypropylene container, 0.40 g of phosphoric acid (manufactured by FUJIFILM Wako Pure Chemical Corporation, product name: phosphoric acid, CAS number: 7664-38-2) and 28.7 g of pure water were put, and 0.85 g of a 5% by mass lithium hydroxide monohydrate aqueous solution was added to the obtained phosphorus compound aqueous solution to obtain a phosphorus compound mixed solution.

Then, 3.02 g of the niobium compound neutralized aqueous solution used in Example 1 was added to the phosphorus compound mixed solution, and the mixture was stirred for 30 minutes and mixed to obtain a niobic acid compound dispersion according to Example 4.

Note that the 5% by mass lithium hydroxide monohydrate aqueous solution used in Example 4 was the same as that in Example 1.

### (Example 5)

In Example 5, into a polypropylene container, 0.38 g of phosphoric acid and 26.7 g of pure water were put, and 2.89 g of a 5% by mass lithium hydroxide monohydrate aqueous solution was added to the obtained phosphorus compound aqueous solution to obtain a phosphorus compound mixed solution.

Then, 2.97 g of the niobium compound neutralized aqueous solution used in Example 1 was added to the phosphorus compound mixed solution, and the mixture was stirred for 30 minutes and mixed to obtain a niobic acid compound dispersion according to Example 5.

Note that the phosphoric acid used in Example 5 was the same as that in Example 4, and the 5% by mass lithium hydroxide monohydrate aqueous solution used in Example 5 was the same as that in Example 1.

### (Example 6)

In Example 6, into a polypropylene container, 0.41 g of phosphoric acid and 25.39 g of pure water were put, and 4.28 g of a 5% by mass lithium hydroxide monohydrate aqueous solution was added to the obtained phosphorus compound aqueous solution to obtain a phosphorus compound mixed solution.

Then, 3.01 g of the niobium compound neutralized aqueous solution used in Example 1 was added to the phosphorus compound mixed solution, and the mixture was stirred for 30 minutes and mixed to obtain a niobic acid compound dispersion according to Example 6.

Note that the phosphoric acid used in Example 6 was the same as that in Example 4, and the 5% by mass lithium hydroxide monohydrate aqueous solution used in Example 6 was the same as that in Example 1.

### (Example 7)

In Example 7, into a polypropylene container, 3.44 g of 1 mol/L hydrochloric acid and 24.01 g of pure water were put, and 4.24 g of a 5% by mass lithium hydroxide monohydrate aqueous solution was added to the obtained chlorine compound aqueous solution to obtain a chlorine compound mixed solution.

Then, 3.27 g of the niobium compound neutralized aqueous solution used in Example 1 was added to the chlorine compound mixed solution, and the mixture was stirred for 30 minutes and mixed to obtain a niobic acid compound dispersion according to Example 7.

Note that the 5% by mass lithium hydroxide monohydrate aqueous solution used in Example 7 was the same as that in Example 1.

### (Example 8)

In Example 8, into a polypropylene container, 0.28 g of phosphonic acid and 27.06 g of pure water were put, and 4.27 g of a 5% by mass lithium hydroxide monohydrate aqueous solution was added to the obtained phosphorus compound aqueous solution to obtain a phosphorus compound mixed solution.

Then, 3.29 g of the niobium compound neutralized aqueous solution used in Example 1 was added to the phosphorus compound mixed solution, and the mixture was stirred for 30 minutes and mixed to obtain a niobic acid compound dispersion according to Example 8.

Note that the 5% by mass lithium hydroxide monohydrate aqueous solution used in Example 8 was the same as that in Example 1.

### (Example 9)

In Example 9, into a polypropylene container, 0.75 g of 30% by mass phosphinic acid and 26.74 g of pure water were put, and 4.22 g of a 5% by mass lithium hydroxide monohydrate aqueous solution was added to the obtained phosphorus compound aqueous solution to obtain a phosphorus compound mixed solution.

Then, 3.29 g of the niobium compound neutralized aqueous solution used in Example 1 was added to the phosphorus compound mixed solution, and the mixture was stirred for 30 minutes and mixed to obtain a niobic acid compound dispersion according to Example 9.

Note that the 5% by mass lithium hydroxide monohydrate aqueous solution used in Example 9 was the same as that in Example 1.

### (Example 10)

In Example 10, into a polypropylene container, 0.29 g of 80% by mass P₂O₅ polyphosphoric acid and 27.15 g of pure water were put, and 4.23 g of a 5% by mass lithium hydroxide monohydrate aqueous solution was added to the obtained phosphorus compound aqueous solution to obtain a phosphorus compound mixed solution.

Then, 3.29 g of the niobium compound neutralized aqueous solution used in Example 1 was added to the phosphorus compound mixed solution, and the mixture was stirred for 30 minutes and mixed to obtain a niobic acid compound dispersion according to Example 10.

Note that the 5% by mass lithium hydroxide monohydrate aqueous solution used in Example 10 was the same as that in Example 1.

### (Comparative Example 1)

In Comparative Example 1, into a polypropylene container, 0.3 g of pyrophosphoric acid and 25.42 g of pure water were put, and 4.21 g of a 5% by mass lithium hydroxide monohydrate aqueous solution was added to the obtained phosphorus compound aqueous solution to obtain a phosphorus compound mixed solution.

Then, 0.16 g of a lithium niobate powder (manufactured by Kojundo Chemical Lab. Co., Ltd.) was added to the phosphorus compound mixed solution, and the mixture was stirred for 30 minutes and mixed to obtain a niobic acid compound dispersion according to Comparative Example 1.

Note that the pyrophosphoric acid and the 5% by mass lithium hydroxide monohydrate aqueous solution used in Comparative Example 1 were the same as those in Example 1.

### (Comparative Example 2)

In Comparative Example 2, into a polypropylene container, 3.33 g of 10% by mass sulfuric acid and 24.13 g of pure water were put, and 4.25 g of a 5% by mass lithium hydroxide monohydrate aqueous solution was added to the obtained sulfur compound aqueous solution to obtain a sulfur compound mixed solution.

Then, 3.28 g of the niobium compound neutralized aqueous solution used in Example 1 was added to the sulfur compound mixed solution, and the mixture was stirred for 30 minutes and mixed to obtain a niobic acid compound dispersion according to Comparative Example 2.

Note that the 5% by mass lithium hydroxide monohydrate aqueous solution used in Comparative Example 2 was the same as that in Example 1.

### (Comparative Example 3)

In Comparative Example 3, to 21.32 g of pure water contained in a polypropylene container, 7.64 g of a 5% by mass lithium hydroxide monohydrate aqueous solution and 5.98 g of the niobium compound neutralized aqueous solution used in Example 1 were added, and the mixture was stirred for 30 minutes and mixed to obtain a niobic acid compound dispersion according to Comparative Example 3.

Note that the 5% by mass lithium hydroxide monohydrate aqueous solution used in Comparative Example 3 was the same as that in Example 1.

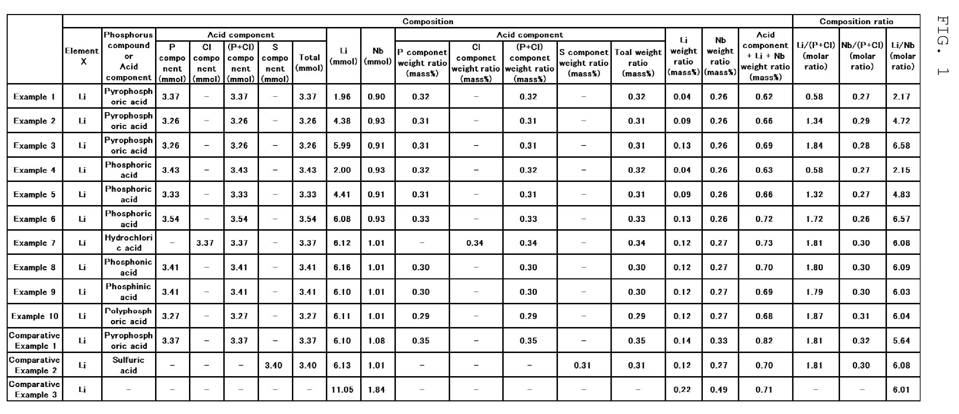

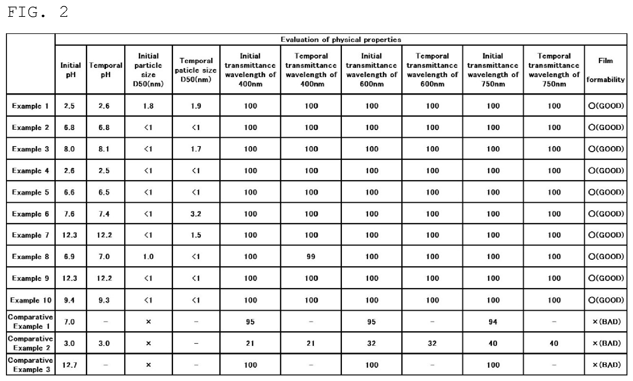

Then, the following physical properties were measured for the niobic acid compound dispersions according to Examples 1 to 10 and Comparative Examples 1 to 3. Hereinafter, measured physical property values and methods for measuring the physical property values are described, and physical property values and measurement results of the niobic acid compound dispersions according to Examples 1 to 10 and Comparative Examples 1 to 3 are illustrated in Figs. 1 and 2.

### <Element analysis>

A sample was appropriately diluted with dilute hydrochloric acid as necessary. For the niobic acid compound dispersions according to Examples 1 to 10 and Comparative Examples 1 to 3, % by mass of Nb in terms of Nb atoms, % by mass of P in terms of P atoms, % by mass of Li in terms of Li atoms, % by mass of Cl in terms of Cl atoms, and % by mass of S in terms of S atoms were measured in accordance with JIS K0116:2014 using ICP emission spectrometry (AG-5110 manufactured by Agilent Technologies).

### <Measurement of pH>

A pH was measured after an electrode (standard ToupH electrode 9615S-10D manufactured by HORIBA, Ltd.) of a pH meter (glass electrode type hydrogen ion concentration indicator D-51 manufactured by HORIBA, Ltd.) was immersed in each of the niobic acid compound dispersions according to Examples 1 to 10 and Comparative Examples 1 to 3 and it was confirmed that a liquid temperature was stabilized at 25°C. The "initial pH" in Fig. 2 refers to the pH of a niobic acid compound dispersion adjusted to a liquid temperature of 25°C immediately after generation. In addition, the "temporal pH" in Fig. 2 refers to the pH of a niobic acid compound dispersion after being allowed to stand in a thermostat set at room temperature of 25°C for one month from the day on which the niobic acid compound dispersions according to Examples 1 to 10 and Comparative Examples 1 to 3 were generated.

### <Dynamic light scattering method>

Evaluation of a particle size distribution was performed by a dynamic light scattering method in accordance with JIS Z 8828:2019 using a zeta potential/particle size/molecular weight measurement system (ELSZ-2000 manufactured by Otsuka Electronics Co., Ltd.). In addition, immediately before measurement, in order to remove dust and the like in the niobic acid compound dispersions according to Examples 1 to 10 to be measured, the dispersions were filtered with a filter having a pore size of 1 µm to perform filtering. Furthermore, D50 represents a particle size reaching 50% in terms of volume fraction. The "initial particle size D50 (nm)" in Fig. 2 refers to a particle size (D50) of particles in a niobic acid compound dispersion immediately after generation. In addition, the "temporal particle size D50 (nm)" in Fig. 2 refers to a particle size (D50) of particles in a niobic acid compound dispersion after being allowed to stand in a thermostat set at room temperature of 25°C for one month from the day on which the niobic acid compound dispersions according to Examples 1 to 10 and Comparative Examples 1 to 3 were generated. In addition, in the niobic acid compound dispersions according to Comparative Examples 1 to 3, since a precipitate was visually recognized, the particle size (D50) was not measured.

### <Measurement of transmittance>

Into a synthetic quartz cell having an optical path length of 5 mm, 3 ml of each of the niobic acid compound dispersions according to Examples 1 to 10 and Comparative Examples 1 to 3 was put, and a transmittance (specifically, transmittances at wavelengths of 400 nm, 600 nm, and 750 nm) of each of the niobic acid compound dispersions according to Examples 1 to 10 and Comparative Examples 1 to 3 in a wavelength region of 400 nm to 760 nm was measured according to the transmittance measurement condition described above using a spectrophotometer. The "initial transmittance" in Fig. 1 refers to the transmittance of a niobic acid compound dispersion adjusted to a liquid temperature of 25°C immediately after generation. In addition, the "temporal transmittance" in Fig. 1 refers to the transmittance of a niobic acid compound dispersion after being allowed to stand in a thermostat set at room temperature of 25°C for one month from the day on which the niobic acid compound dispersions according to Examples 1 to 10 and Comparative Examples 1 to 3 were generated.

### <Film formability test>

Appearance of a coating film formed on a surface of a glass substrate as a substitute for a current collecting plate was evaluated by observing the coating film with an optical microscope. First, the niobic acid compound dispersions according to Examples 1 to 10 and Comparative Examples 1 to 3 were allowed to stand in a thermostat set at room temperature of 25°C for one month from the day on which the niobic acid compound dispersions according to Examples 1 to 10 and Comparative Examples 1 to 3 were generated. Next, using a syringe, the niobic acid compound dispersions according to Examples 1 to 10 and Comparative Example 1 after being allowed to stand for one month were dropped onto a 50 mm × 50 mm glass substrate which had been degreased and cleaned with acetone and dried while the niobic acid compound dispersions were filtered with a filter having a pore size of 0.22 µm, and applied thereto by spin coating (700 rpm, after 10 seconds, 1500 rpm, 15 seconds). Then, the applied portion was naturally dried to form a coating film on the glass substrate. The glass substrate was observed with an optical microscope (magnification: 40 times) in a range of 15 mm×15 mm at a center of the formed coating film. A glass substrate in which no particles were present and a film was formed was evaluated as "∘ (GOOD)" as having excellent film formability, and a glass substrate in which particles were observed was evaluated as " × (BAD)" as having no excellent film formability.

### <³¹P-NMR spectrum measurement>

The phosphorus content in each of the niobic acid compound dispersions according to Examples 3 and 6 was calculated using a ³¹P-NMR spectrum. Specifically, by mixing 70 µL of each of the niobic acid compound dispersions according to Examples 3 and 6 and 650 µL of a phosphonoacetic acid heavy water solution obtained by dissolving 10 g/L of phosphonoacetic acid in heavy water, a measurement sample was prepared. By performing Fourier transform on FID data of the adjusted measurement sample, measured under the above-described ³¹P-NMR spectrum measurement conditions without using a window function, a ³¹P-NMR spectrum was obtained. A peak area for the ³¹P-NMR spectrum was calculated using an Integrate function of the above-described measurement and data processing software, and the contents of phosphonoacetic acid and phosphate ions in each of the niobic acid compound dispersions according to Examples 3 and 6 were calculated from the peak area.

As illustrated in Figs. 1 and 2, when each of the niobic acid compound dispersions according to Examples 1 to 10 contained niobium, contained one or more elements X selected from the group consisting of alkali metal elements and/or alkaline earth metal elements, and a phosphorus compound and/or a chlorine compound, and a particle size (D50) of particles in each of the niobic acid compound dispersions as measured by a dynamic light scattering method was 1000 nm or less, each of the niobic acid compound dispersions had high dispersibility and excellent solubility in a dispersion medium.

When each of the niobic acid compound dispersions according to Examples 1 to 10 contained niobium, contained one or more elements X selected from the group consisting of alkali metal elements and/or alkaline earth metal elements, and a phosphorus compound and/or a chlorine compound, and had a maximum transmittance value of 70%T or more in a wavelength region of 400 nm to 760 nm, each of the niobic acid compound dispersions had high dispersibility and excellent solubility in a dispersion medium.

When each of the niobic acid compound dispersions according to Examples 1 to 10 had a niobium content of 0.01% by mass or more and 30% by mass or less in terms of Nb atoms in each of the niobic acid compound dispersions according to Examples 1 to 10, each of the niobic acid compound dispersions had excellent temporal stability.

When each of the niobic acid compound dispersions according to Examples 1 to 10 had a phosphorus content of 0.01% by mass or more and 10% by mass or less in terms of P atoms in each of the niobic acid compound dispersions according to Examples 1 to 10, each of the niobic acid compound dispersions had excellent temporal stability.

Each of the niobic acid compound dispersions according to Examples 1 to 10 had a temporal particle size (D50) that was not significantly different from the initial particle size (D50) even after a lapse of one month, and had excellent temporal stability. Note that, in the niobic acid compound dispersion according to Comparative Example 1, a precipitate was observed.

In each of the niobic acid compound dispersions according to Examples 1 to 10, when a molar ratio M/Nb of the total amount (M) of one or more elements X selected from the group consisting of alkali metal elements and/or alkaline earth metal elements to niobium (Nb) was 0.01 or more and 10 or less, stability during long-term storage was improved. Furthermore, in each of the niobic acid compound dispersions according to Examples 1 to 6, in a case where the element X is Li, when a molar ratio Li/Nb of lithium (Li) to niobium (Nb) was 0.01 or more and 10 or less, stability during long-term storage was improved.

In each of the niobic acid compound dispersions according to Examples 1 to 10, when a molar ratio M/(P+Cl) of the total amount (M) of one or more elements X selected from the group consisting of alkali metal elements and/or alkaline earth metal elements to the total amount (P+Cl) of a phosphorus compound and/or a chlorine compound was 0.01 or more and 10 or less, stability during long-term storage was improved. Furthermore, in each of the niobic acid compound dispersions according to Examples 1 to 10, in a case where the element X is Li, when a molar ratio Li/(P+Cl) of lithium (Li) to the total amount (P+Cl) of a phosphorus compound and/or a chlorine compound was 0.01 or more and 10 or less, stability during long-term storage was improved. Note that the column "Li/ (P+Cl)" of the niobic acid compound dispersion according to Comparative Example 2 in Fig. 1 indicates a value of a molar ratio "Li/(P+S)", in which "S" is a value determined in terms of S atoms.

In each of the niobic acid compound dispersions according to Examples 1 to 10, when a molar ratio Nb/(P+Cl) of niobium (Nb) to the total amount (P+Cl) of a phosphorus compound and/or a chlorine compound was 0.01 or more and 10 or less, stability during long-term storage was improved. Note that the column "Nb/(P+Cl)" of the niobic acid compound dispersion according to Comparative Example 2 in Fig. 1 indicates a value of a molar ratio "Nb/(P+S)", in which "S" is a value determined in terms of S atoms.

When each of the niobic acid compound dispersions according to Example 1 to 10 had a pH of 2 or more and 11 or less, each of the niobic acid compound dispersions according to Example 1 to 10 had excellent temporal stability.

In the niobic acid compound films formed from the niobic acid compound dispersions according to Examples 1 to 10, as a result of observing the coating films formed from the niobic acid compound dispersions with an optical microscope, coarse particles were not present in the coating films, and film formability was excellent.

Results of the ³¹P-NMR spectrum measurement are as follows. The niobic acid compound dispersion according to Example 3 had a PO₄ ion concentration of 4.0 mg/mL (42 mmol/L) and a P₂O₇ ion concentration of 1.9 mg/mL (11 mmol/L), which was 64 mmol/L in terms of a molar concentration of phosphorus in the niobic acid compound dispersion, and 2.0 g/L in terms of the weight of phosphorus in the niobic acid compound dispersion. The niobic acid compound dispersion according to Example 6 had a PO₄ ion concentration of 7.4 mg/mL (78 mmol/L), which was 78 mmol/L in terms of a molar concentration of phosphorus in the niobic acid compound dispersion, and 2.4 g/L in terms of the weight of phosphorus in the niobic acid compound dispersion.

The invention disclosed in the present specification includes, in addition to configurations of the inventions and the embodiments, those specified by changing partial configurations thereof to other configurations disclosed in the present specification, those specified by adding other configurations disclosed in the present specification to these configurations, and those specified by deleting these partial configurations to an extent that partial action and effect can be obtained and forming a superordinate concept.

### Industrial Applicability

The niobic acid compound dispersion according to the present invention has high dispersibility in a polar solvent, particularly water, has favorable solubility in water, and excellent storage stability. In addition, since the niobic acid compound dispersion according to the present invention has excellent storage stability and can suppress a generation ratio of defective products due to generation of a precipitate by a temporal change, it is possible to reduce waste and to reduce energy cost in waste disposal. These points lead to achieving sustainable management and efficient advantages of natural resources, and decarbonization (carbon neutral).

## Claims

1. A niobium-containing niobic acid compound dispersion, comprising:
one or more elements X selected from the group consisting of alkali metal elements and/or alkaline earth metal elements; and
a phosphorus compound and/or a chlorine compound, wherein
a particle size (D50) of particles in the niobic acid compound dispersion as measured by a dynamic light scattering method is 1000 nm or less.

2. A niobium-containing niobic acid compound dispersion, comprising:
one or more elements X selected from the group consisting of alkali metal elements and/or alkaline earth metal elements; and
a phosphorus compound and/or a chlorine compound, wherein
a maximum transmittance value in a wavelength region of 400 nm to 760 nm is 70%T or more.

3. The niobic acid compound dispersion according to claim 1 or 2, wherein the element X contains Li.

4. The niobic acid compound dispersion according to claim 1 or 2, wherein the phosphorus compound contains one or more selected from an inorganic phosphorus compound, an organic phosphorus compound, and a salt thereof.

5. The niobic acid compound dispersion according to claim 3, wherein the phosphorus compound contains one or more selected from condensed phosphoric acid, pyrophosphoric acid, polyphosphoric acid, phosphorous acid, hypophosphorous acid, ammonium phosphate, primary ammonium phosphate, secondary ammonium phosphate, ammonium pyrophosphate, and ammonium polyphosphate.

6. The niobic acid compound dispersion according to claim 1 or 2, further comprising ammonia and/or an organic nitrogen compound.

7. The niobic acid compound dispersion according to claim 1 or 2, wherein a niobium content in the niobic acid compound dispersion is 0.01% by mass or more and 30% by mass or less in terms of Nb atoms.

8. The niobic acid compound dispersion according to claim 1 or 2, wherein a phosphorus content in the niobic acid compound dispersion is 0.01% by mass or more and 10% by mass or less in terms of P atoms.

9. The niobic acid compound dispersion according to claim 1 or 2, wherein a molar ratio M/Nb of a total amount (M) of the elements X to niobium (Nb) in the niobic acid compound dispersion is 0.01 or more and 10 or less.

10. The niobic acid compound dispersion according to claim 1 or 2, wherein the element X in the niobic acid compound dispersion is Li, and a molar ratio Li/Nb of lithium (Li) to niobium (Nb) is 0.01 or more and 10 or less.

11. The niobic acid compound dispersion according to claim 1 or 2, wherein a molar ratio M/(P+Cl) of a total amount (M) of the elements X to a total amount (P+Cl) of the phosphorus compound and/or the chlorine compound in the niobic acid compound dispersion is 0.01 or more and 10 or less.

12. The niobic acid compound dispersion according to claim 1 or 2, wherein the element X in the niobic acid compound dispersion is Li, and a molar ratio Li/(P+Cl) of lithium (Li) to a total amount (P+Cl) of the phosphorus compound and/or the chlorine compound is 0.01 or more and 10 or less.

13. The niobic acid compound dispersion according to claim 1 or **2,** wherein a molar ratio Nb/(P+Cl) of niobium (Nb) to a total amount (P+Cl) of the phosphorus compound and/or the chlorine compound in the niobic acid compound dispersion is 0.01 or more and 10 or less.

14. The niobic acid compound dispersion according to claim 1 or **2,** wherein the niobic acid compound dispersion is an aqueous dispersion.

15. The niobic acid compound dispersion according to claim 1 or 2, wherein a particle size (D50) of particles in the niobic acid compound dispersion as measured by a dynamic light scattering method is 100 nm or less.

16. The niobic acid compound dispersion according to claim 1 or 2, wherein a pH of the niobic acid compound dispersion is 2 or more and 11 or less.

17. A niobic acid compound powder comprising a niobic acid compound in the niobic acid compound dispersion according to claim 1 or 2.

18. A niobic acid compound film comprising a niobic acid compound in the niobic acid compound dispersion according to claim 1 or 2.

19. A coating agent comprising the niobic acid compound dispersion according to claim 1 or 2.

20. A coating agent comprising the niobic acid compound powder according to claim 17.

21. The niobic acid compound dispersion according to claim 1 or 2, which is used for coating a lithium ion secondary battery positive electrode or a positive electrode material.

22. A lithium ion secondary battery positive electrode active material whose surface is coated with a niobic acid compound contained in the niobic acid compound dispersion according to claim 1 or 2.

23. A lithium ion secondary battery comprising a positive electrode whose surface is coated with the lithium ion secondary battery positive electrode active material according to claim 22.
